(19) Europäisches Patentamt
European Patent Office
Office européen des brevets

(11) EP 1 536 487 A1

(12) EUROPEAN PATENT APPLICATION
published in accordance with Art. 158(3) EPC

(43) Date of publication:
01.06.2005 Bulletin 2005/22

(51) Int Cl.⁷: H01L 33/00, F21V 8/00

(21) Application number: 03755289.0

(86) International application number:
PCT/JP2003/006715

(22) Date of filing: 28.05.2003

(87) International publication number:
WO 2003/100873 (04.12.2003 Gazette 2003/49)

(84) Designated Contracting States:
AT BE BG CH CY CZ DE DK EE ES FI FR GB GR
HU IE IT LI LU MC NL PT RO SE SI SK TR
Designated Extension States:
AL LT LV MK

(30) Priority: 28.05.2002 JP 2002154262
26.07.2002 JP 2002218891

(71) Applicant: Matsushita Electric Works, Ltd.
Kadoma-shi, Osaka-fu 571-8686 (JP)
(72) Inventors:
• Yokotani, Ryoji
Kadoma-shi, Osaka 571-8686 (JP)
• YAMAGUCHI, Masao
Misato-shi, Saitama 341-0044 (JP)

(74) Representative: Mackenzie, Andrew Bryan et al
Marks & Clerk
45 Grosvenor Road
St. Albans, Hertfordshire AL1 3AW (GB)

(54) **LIGHT EMITTING ELEMENT, LIGHT EMITTING DEVICE AND SURFACE EMISSION ILLUMINATING DEVICE USING IT**

(57) In a non-sealed type light emitting device in which a diode structure on a face of a transparent substrate by lamination of an n-type semiconductor layer and a p-type semiconductor layer, an outer face of the transparent substrate is made not in parallel with a most outer face of the diode structure by, for example, being slanted so as to increase a light taking efficiency from an exit face of light. An incident angle of a light beam entering into an exit face of light is gradually reduces by repeating total reflection on these two faces so as to make is smaller than a critical angle, and to emit the light beams outward of the light emitting device.

FIG. 1

**Description**

**Technical Field**

The present invention relates to a light emitting device in which a light taking efficiency is increased, a lighting apparatus and a surface emitting illumination system using the device.

**Background Art**

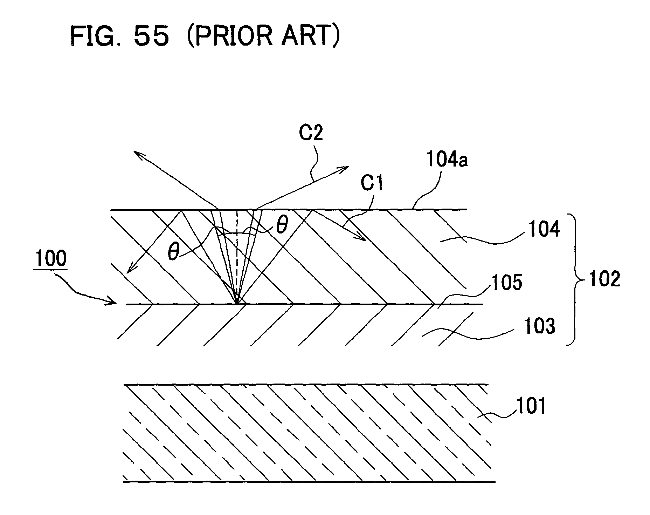

A configuration of a conventional non-sealed type light emitting device is shown in FIG. 55. The conventional non-sealed type light emitting device 100 has a transparent substrate 101 made of SiC or sapphire, and a diode structure 102 consisting of an n-type semiconductor layer 103 and a P-type semiconductor layer 104 formed on a face of the transparent substrate 101. Light generated on a pn-composition face 105 of the n-type semiconductor layer 103 and the P-type semiconductor layer 104 is mainly emitted from an outer face of the diode structure 102 substantially in parallel with the pn-composition face 105, that is, a surface 104a of the p-type semiconductor layer 104 or a surface of the transparent substrate 101 (not shown in the figure).

On the exit face 104a of light, refraction occurs due to difference between a refraction index of an inner material and a refraction index of outer medium. As shown in FIG. 55, a light beam C1 having an incident angle equal to or larger than the critical angle is totally reflected on the exit face 104a so as not to exit to outward from the exit face 104a, and proceeds in the light emitting device 100.

The light beam C 1 totally reflected on the exit face 104a proceeds the inside of the light emitting device 100, and is totally reflected on an opposite face to the exit face 104a (for example, the face of the transparent substrate 101), and enters on the exit face 104a, again. The surfaces of the diode structure 102 and the surfaces of the transparent substrate 101 are, however, substantially in parallel with each other, so that the incident angle of the reflected light beam on the exit face 104 rarely changes. Accordingly, the light beam C 1 totally reflected on the exit face 104a is repeated the total reflection in the light emitting device 100 without exiting outward. A part of the light beam is absorbed by materials constituting the light emitting device 100 in such a process, so that the light beam repeated the total reflection in the light emitting device 100 is finally absorbed in the light emitting device 100. Thus, light beams exit outward from the light emitting device 100 becomes only light beams C2 having incident angle equal to or smaller than the critical angle among the light beams directly entering into the exit face 104a from the pn-composition face 105.

It is assumed that the materials of the n-type semiconductor layer 103 and the p-type semiconductor layer 104 are GaN and a material of the transparent substrate is sapphire, the refraction index of GaN is about 2.5 and the refraction index of sapphire is about 1.77, which are respectively very larger values. It is further assumed that the light emitting device 100 is not sealed by a resin, as shown in FIG. 55 and the outer medium is air, the critical angle on the exit face 104a of the light $\theta_{critical}$=about 23.5 degrees. Alternatively, when the exit face of the light is assumed as the surface of the transparent substrate 101, the critical angle $\theta_{critical}$=about 34.4 degrees. In each case, the critical angle of the exit light beam on the exit face becomes a small angle.

As mentioned above, the light beams exiting outward from the light emitting device 100 are limited to components having incident angles equal to or smaller than the critical angle among the light beams directly entering into the exit face 104a from the pn-composition face 105. Therefore, since the critical angle in the light emitting device 100 of the non-sealed structure is a very small value such as $\theta_{critical}$=about 23.5 degrees or $\theta_{critical}$=about 34.4 degrees, the light taking efficiency to an air medium with respect to the light beams generated on the pn-composition face 105 becomes equal to or smaller than about 20%.

Then, for increasing the light taking efficiency to the air medium, a circumference of the light emitting device 100 is conventionally sealed widely by a transparent resin layer such as an epoxy-resin having transparency and a relatively higher refraction index, so as to reduce a difference between the refraction indexes of the materials on both side of a boundary face of the light emitting device 100 and the transparent resin layer (for example, the surface 104a of the p-type semiconductor layer 104), and to enlarge the critical angle.

In case of sealing the circumference of the light emitting device 100 by the transparent resin layer as just described, the light taking efficiency into the transparent resin layer from the light emitting device 100 is increased, but the refraction occurs on a boundary face between a surface of the transparent resin layer and the air medium due to the difference of the refraction indexes. Thus, the light taking efficiency into the air medium will be varied corresponding to the shape of the surface of the transparent resin layer.

In case, for example, that the surface of the diode structure and the surface of the transparent resin layer are substantially in parallel with each other, the critical angles $\theta_0$ and $\theta_1$ are shown by the following equations. Hereupon, the refraction index of the material constituting the diode structure is designated bay $n_0$; the refraction index of the transparent resin layer is designated by $n_1$; the refraction index of the outer medium is designated by $n_2$; and the critical angle on the boundary face between the diode structure and the transparent resin layer is designated by $\theta_0$, and the

critical angle on the boundary face between the transparent resin layer and the outer medium is designated by $\theta_1$, when the total reflection occurs on the boundary face between the transparent resin layer and the outer medium.

$$\theta_0 = \sin^{-1}(n_1/n_0)$$

$$\theta_1 = \sin^{-1}(n_2/n_1)$$

Hereupon, a relation $n_0 \times \sin \theta_0 = n_1 \times \sin \theta_1$ exists.

$$\sin \theta_0 = (n_1/n_0) \times \sin \theta_1$$

$$= (n_1/n_0) \times \sin(\sin^{-1}(n_2/n_1))$$

$$= (n_1/n_0) \times (n_2/n_1) = n_2/n_0$$

Accordingly, the critical angle of the light beam emitted from the diode structure to the outer medium becomes $\sin^{-1}(n_2/n_0)$. In other words, it is shown by the same equation as that of the critical angle $\theta_0$ in case that the diode structure is not sealed by the transparent resin layer. When the surface of the diode structure and the surface of the transparent resin layer are substantially in parallel with each other, the critical angle depends on only the refraction index of the material constituting the diode structure and the refraction index of the air, so that it is impossible to increase the light taking efficiency, even though it is sealed by the transparent resin layer.

On the other hand, when the transparent resin layer is made larger so that the light emitting device can be regarded as a point light source, and an exit face of the transparent resin layer is made substantially spherical so that the light beam emitted from the light emitting device enters substantially perpendicular to the exit face, it is possible to reduce the total reflection on the boundary face between the transparent resin layer and the outer medium as smaller as possible and to make the light beam exits to the air medium the largest. In such a case, the light taking efficiency to the air medium becomes about 35 to 40% of the light beams generated on the pn-composition face.

As mentioned above, in the conventional non-sealed light emitting device, the light taking efficiency to the air medium is very small. On the other hand, in the sealed type light emitting device sealed by the transparent resin, though the light taking efficiency to the air medium is increased, the light emitting device (light emitting unit) is sealed by the transparent resin layer having a small coefficient of thermal conductivity. Thus, heat generated in the light emitting device is radiated only by transmitting outward via electrodes or wires, so that the heat radiation performance is lower and the operating life of the light emitting device becomes shorter.

Furthermore, in case that the color of light emission of the light emitting device is blue or ultraviolet, a flux density in a region of short-wavelength is larger, so that the transparent resin layer sealing the light emitting portion is easily deteriorated, and the operating life of the light emitting device becomes shorter. Still furthermore, the size of the transparent resin layer sealing the light emitting device is much larger than that of the light emitting device, so that the light emitting device is entirely upsized, and the cost of material becomes expensive.

**Disclosure of Invention**

The present invention is to solve the problems of the above-mentioned conventional light emitting device, and purposed to elongate the operating life of the non-sealed type light emitting device, and to provide a light emitting device by which the light taking efficiency equivalent to that in the highest level of the conventional light emitting device with sealed structure can be obtained, and to provide a lighting apparatus and a surface emitting illumination apparatus using the device.

A light emitting device in accordance with a first aspect of the present invention is a non-sealed type light emitting device having a diode structure which is formed by lamination of an n-type semiconductor layer and a p-type semiconductor layer on a surface of a transparent substrate, and characterized by that an exit face of light is not in parallel with a surface among respective surfaces of the diode structure which is opposite to the transparent substrate.

By such a configuration, a light beam, which was repeated the total reflection between an exit face of light of the light emitting device and another face and absorbed by a material constituting the light emitting device if it was the conventional lighting device, exits outward from the exit face of light, since an incident angle on the exit face of light becomes gradually smaller when it repeats the total reflection, and becomes smaller than the critical angle. As a result, the light taking efficiency of light emitted outward from the light emitting device can be increased. Consequently, even though the non-sealed type light emitting device, it is possible to obtain the light taking efficiency equivalent to that in the highest level in the conventional sealed type light emitting device. Furthermore, since the light emitting device is not sealed by a resin, it is possible to downsize the light emitting device itself, and the cost of materials can be made inexpensive. Still furthermore, it is possible to mount the light emitting device on a mounting substrate in both of face down and face up situations.

Furthermore, a lighting apparatus in accordance with a second aspect of the present invention comprises a non-sealed type light emitting apparatus mounted on a mounting substrate, and a fluorescent member disposed in front of an exit face of light of the light emitting device, which is excited by a light emitted from the light emitting device and emits a light of different wavelength from excitation wavelength, and characterized by that the light emitting device has a diode structure which is formed by lamination of an n-type semiconductor layer and a p-type semiconductor layer on a surface of a transparent substrate, and the exit face of light is not in parallel with a surface among respective surfaces of the diode structure which is opposite to the transparent substrate.

By such a configuration, since the lighting apparatus utilizing wavelength conversion of fluorescent substance is configured with using the light emitting device in accordance with the first aspect of the present invention, a light emitting unit of the lighting apparatus can be downsized and the lighting apparatus itself can be downsized. Especially, by using a plurality of downsized lighting devices, it is possible to provide a lighting apparatus having a size equivalent to that of the conventional one but a higher luminance of light emission.

Still furthermore, a surface emitting illumination apparatus in accordance with a third aspect of the present invention comprises one or a plurality of non-sealed type light emitting apparatuses mounted on a mounting substrate, and a fluorescent member which is excited by a light emitted from the light emitting device and emits a light of different wavelength from excitation wavelength, and characterized by that the light emitting device has a diode structure which is formed by lamination of an n-type semiconductor layer and a p-type semiconductor layer on a surface of a transparent substrate, and the exit face of light is not in parallel with a surface among respective surfaces of the diode structure which is opposite to the transparent substrate.

By such a configuration, since the surface emitting illumination apparatus utilizing wavelength conversion of fluorescent substance is configured with using the light emitting device in accordance with the first aspect of the present invention, a more larger number of light emitting devices can be mounted on a housing of the same size as that of the conventional one, and the surface emitting illumination apparatus of higher luminance can be provided. Furthermore, by selecting a shape of the exit face of light of the light emitting device properly, distribution of light can optionally be controlled, so that it is possible to provide the surface emitting illumination apparatus having the distribution of light more even.

**Brief Description of Drawings**

FIG. 1 is a cross-sectional view showing a configuration of a light emitting device in accordance with a first embodiment of the present invention;

FIG. 2 is a drawing showing optical paths in the light emitting device in accordance with the first embodiment;

FIG. 3 is a cross-sectional view showing a configuration of a modified example of the lighting apparatus in accordance with the first embodiment;

FIG. 4 is a cross-sectional view showing a method for fixing a slanted plate in the modified example shown in FIG. 3;

FIG. 5 is a cross-sectional view showing a configuration of a light emitting device in accordance with a second embodiment of the present invention;

FIG. 6A is a drawing showing an optical path in the light emitting device in accordance with the second embodiment;

FIG. 6B is a drawing showing an optical path in the light emitting device in accordance with the second embodiment;

FIG. 6C is a drawing showing an optical path in the light emitting device in accordance with the second embodiment;

FIG. 7 is a cross-sectional view showing a configuration of a modified example of the lighting apparatus in accordance with the second embodiment;

FIG. 8 is a cross-sectional view showing a configuration of another modified example of the lighting apparatus in accordance with the second embodiment;

FIG. 9A is a plan view showing a first example of configuration of a light emitting device in accordance with a third embodiment of the present invention;

FIG. 9B is a cross-sectional view of the above-mentioned first example;

FIG. 10 is a graph showing a relation between a ratio of a height with respect to the largest width of a bottom face of a transparent substrate of quadrangular pyramid and light taking efficiency in the third embodiment;

FIG. 11A is a plan view showing a second example of configuration of a light emitting device in accordance with the third embodiment;

FIG. 11B is a cross-sectional view of the above-mentioned second example;

FIG. 12A is a plan view showing a third example of configuration of a light emitting device in accordance with the third embodiment;

FIG. 12B is a cross-sectional view of the above-mentioned third example;

FIG. 13 is a graph showing a relation between a ratio of a height with respect to a diameter of a bottom face of a transparent substrate of substantially hemisphere and light taking efficiency in the third embodiment;

FIG. 14A is a plan view showing a first example of configuration of a light emitting device in accordance with a fourth embodiment of the present invention;

FIG. 14B is a cross-sectional view of the above-mentioned first example;

FIG. 15A is a plan view showing a second example of configuration of a light emitting device in accordance with the fourth embodiment;

FIG. 15B is a cross-sectional view of the above-mentioned second example;

FIG. 16A is a plan view showing a third example of configuration of a light emitting device in accordance with the fourth embodiment;

FIG. 16B is a cross-sectional view of the above-mentioned third example;

FIG. 17 is a cross-sectional view showing a modified example of the light emitting device in accordance with the fourth embodiment;

FIG. 18 is a cross-sectional view showing another modified example of the light emitting device in accordance with the fourth embodiment;

FIG. 19 is a cross-sectional view showing a first example of configuration of a light emitting device in accordance with a fifth embodiment of the present invention;

FIG. 20 is a cross-sectional view showing a second example of configuration of a light emitting device in accordance with the fifth embodiment;

FIG. 21 is a cross-sectional view showing a third example of configuration of a light emitting device in accordance with the fifth embodiment;

FIG. 22 is a cross-sectional view showing a fourth example of configuration of a light emitting device in accordance with the fifth embodiment;

FIG. 23 is a cross-sectional view showing a fifth example of configuration of a light emitting device in accordance with the fifth embodiment;

FIG. 24 is a cross-sectional view showing a sixth example of configuration of a light emitting device in accordance with the fifth embodiment;

FIG. 25 is a cross-sectional view showing a configuration of a light emitting device in accordance with a sixth embodiment of the present invention;

FIG. 26 is a cross-sectional view showing a configuration of a light emitting device in accordance with a seventh embodiment of the present invention;

FIG. 27 is a cross-sectional view showing a modified example of the light emitting device in accordance with the seventh embodiment;

FIG. 28 is a cross-sectional view showing a configuration of a lighting apparatus in accordance with an eighth embodiment of the present invention;

FIG. 29 is a cross-sectional view showing a configuration of a modified example of the lighting apparatus in accordance with the eighth embodiment;

FIG. 30 is a cross-sectional view showing a configuration of another modified example of the lighting apparatus in accordance with the eighth embodiment;

FIG. 31 is a cross-sectional view showing a configuration of still another modified example of the lighting apparatus in accordance with the eighth embodiment;

FIG. 32 is a cross-sectional view showing a configuration of a lighting apparatus in accordance with a ninth embodiment of the present invention;

FIG. 33 is a cross-sectional view showing a configuration of a modified example of the lighting apparatus in accordance with the ninth embodiment;

FIG. 34 is a cross-sectional view showing a first example of configuration of a concave portion for mounting a light emitting device on a mounting substrate in a lighting apparatus in accordance with a tenth embodiment of the present invention;

FIG. 35 is a cross-sectional view showing a second example of configuration of the tenth embodiment;

FIG. 36 is a cross-sectional view showing a first example of a method for fixing a light emitting device on a concave portion of a mounting substrate in a lighting apparatus in accordance with an eleventh embodiment of the present invention;

FIG. 37 is a cross-sectional view showing a second example of configuration of the eleventh embodiment;

FIG. 38 is a graph showing a relation between a refraction index n1 of a transparent middle layer and a critical angle in a second example of configuration of the eleventh embodiment;

FIG. 39 is a cross-sectional view showing a third example of configuration of the eleventh embodiment;

FIG. 40 is a cross-sectional view showing a first example of configuration of a surface emitting illumination apparatus in accordance with a twelfth embodiment of the present invention;

FIG. 41 is a graph showing a distribution of light of a conventional light emitting device;

FIG. 42 is a drawing for explaining a light beam $\phi$ which is emitted from an area having an optional angle $\alpha$ with respect to a vertical axis in case of complete diffusion light distribution;

FIG. 43 is a graph showing distribution of light of a light emitting device having a transparent substrate or a transparent member of circular cone apex angle of which is 20 degrees;

FIG. 44 is a graph showing distribution of light of a light emitting device having a transparent substrate or a transparent member of circular cone apex angle of which is 40 degrees;

FIG. 45 is a graph showing distribution of light of a light emitting device having a transparent substrate or a transparent member of circular cone apex angle of which is 60 degrees;

FIG. 46A is a perspective view showing a configuration of a lighting apparatus with using a transparent substrate or a transparent member of triangular prism shape, which is used in a surface emitting illumination apparatus in accordance with the twelfth embodiment;

FIG. 46B is a perspective view showing a configuration of a modified example of the lighting apparatus used in a surface emitting illumination apparatus in accordance with the twelfth embodiment;

FIG. 47 is a graph showing distribution of light of the lighting apparatus using the transparent substrate of triangular prism shape;

FIG. 48 is a cross-sectional view showing a second example of configuration of the twelfth embodiment;

FIG. 49 is an enlarged cross-sectional view showing a relation between an apex angle $\gamma_2$ of the transparent substrate or the transparent member and a base angle $\gamma_1$ of a concave portion of a light guide member in the second example of configuration of the twelfth embodiment;

FIG. 50 is a graph showing a ratio directly emitted without reflecting in the light guide member when the base angle $\gamma_1$ is varied;

FIG. 51 is a cross-sectional plan view showing a configuration of a surface emitting illumination apparatus in accordance with a thirteenth embodiment of the present invention;

FIG. 52 is a cross-sectional front view of the surface emitting illumination apparatus shown in FIG. 51;

FIG. 53 is a perspective view showing a configuration of a light emitting device used in the surface emitting illumination apparatus of the thirteenth embodiment;

FIG. 54 is a graph showing distribution of light of a light emitting device having a transparent substrate or a transparent member of cylindrical lens shape; and

FIG. 55 is a drawing showing optical paths that lights generated on a pn-composition face are emitted from an exit face in a conventional non-sealed type light emitting device.

**Best Mode for Carrying Out the Invention**

First Embodiment

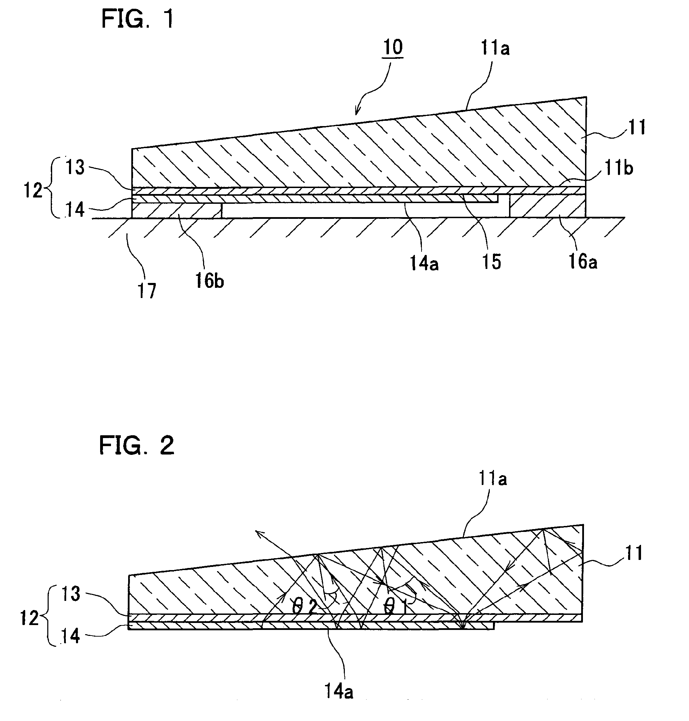

A first embodiment of the present invention is described. FIG. 1 is a cross-sectional view showing a configuration of a light emitting device 10 in accordance with the first embodiment. The light emitting device 10 has a transparent substrate 11 made of, for example, sapphire, and a diode structure 12 consisting of a lamination of an n-type semiconductor layer 13 and a p-type semiconductor layer 14 provided on a lower face 11b of the transparent substrate 11. The transparent substrate 11 is formed of a shape that an upper face 11a in a cross-section in a direction of lamination of the p-type semiconductor layer 13 and the n-type semiconductor layer 14 of the diode structure 12 is slanted with respect to the lower face 11b, and a cross-section in a direction perpendicular to the direction of lamination is substantially rectangular shape. Bump electrodes 16a and 16b are respectively provided on faces of the n-type semiconductor layer 13 and the p-type semiconductor layer 14 opposite to the transparent substrate 11, and the light emitting device is mounted on a mounting substrate 17 in a face down situation (flip-chip mounting).

In the first embodiment, the upper face 11a of the transparent substrate 11 serves as an exit face of light (hereinafter, it is called "exit face 11a"), and the exit face 11a is slanted with respect to a face among respective faces of the diode structure 12 opposite to the transparent substrate 11, that is a lower face 14a of the p-type semiconductor layer 14 so as not to be in parallel. When light beams generated on a pn-composition face 15 enter into the exit face 11a, components having an incident angle with respect to the exit face 11a smaller than a critical angle among the incident light beams are emitted outward, and components larger than the critical angle are totally reflected on the exit face 11a and proceed in the light emitting device 10. Subsequently, the light beams, having the incident angle equal to or larger than the critical angle among the light beams entering into the lower face 14a of the p-type semiconductor layer 14 and side faces of the transparent substrate 11, are totally reflected again, and proceed in the inside of the light emitting device 10 toward the exit face 11 a.

Optical paths in the light emitting device 10 is shown in FIG. 2. As shown in the figure, since the exit face 11 a is slanted with respect to the lower face 14a of the p-type semiconductor layer 14, the incident angles θ 1, θ 2 ··· on the exit face 11a of the light beams, which are repeated the total reflection between the exit face 11a and the lower face 14a of the p-type semiconductor layer 14, becomes gradually smaller. Subsequently, when the incident angle on the exit face 11 a becomes smaller than the critical angle, it is emitted outward from the exit face 11a. Consequently, a ratio of the light beams emitted outward from the exit face 11a, that is, the light taking efficiency can be increased.

Furthermore, since the light emitting device 10 itself is not sealed by the transparent resin, there is no problem that the operation life of the light emitting device is shortened due to deterioration of the transparent resin. Still furthermore, the diode structure 12 directly contacts the air, so that heat radiation performance thereof is increased, and it is possible to elongate the operation life of the light emitting device 10. Still furthermore, since the heat radiation performance of the diode structure 12 is increased, it is possible to flow a larger current and to obtain larger light beams, if the temperature rise in the same level as that in the case of sealed by the transparent resin can be permitted. Still furthermore, the diode structure 12 is not sealed by the transparent resin, so that the manufacturing cost thereof can be reduced in comparison with the case of sealed by the resin. Still furthermore, the light emitting device 10 itself can be downsized. Consequently, an appliance, on which the light emitting device 10 in accordance with the first embodiment is mounted, can be downsized entirely.

By the way, the material of the transparent substrate 11 is not limited to sapphire, and it is needless to say that substantially the same effect can be obtained even when another transparent material such as SiC, glass, or acrylic resin is used. Furthermore, it is, similarly, possible to increase the light taking efficiency without sealing the light emitting device 10 by the resin, when a total reflection process is carried out on the slanted face 11 a of the transparent substrate 11 by coating Al, Ag, or the like, and the above-mentioned light emitting device 10 is mounted on a mounting substrate in face up situation. In such a case, the face 14a of the p-type semiconductor layer 14, however, serves as the exit face. Still furthermore, it is possible to obtain substantially the same effect, when the semiconductor face 14a is slanted so as not to be in parallel with the face 11b of the transparent substrate in face up situation.

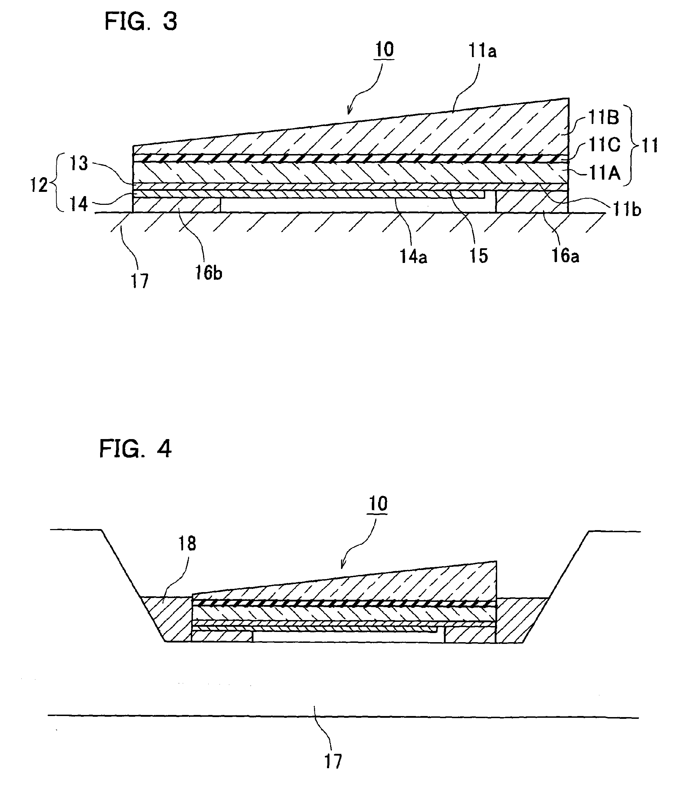

Subsequently, a modified example of the light emitting device 10 in accordance with the first embodiment is shown in FIG. 3. In this modified example, the transparent substrate 11 is constituted by a parallel-plate 11A made of, for example, sapphire, and a transparent member (slanted plate) 11B made of, for example, acrylic resin, or the like, and the parallel-plate 11A and the transparent member 11B are adhered by, for example, an adhesive having transparency and a high refraction index or a silicone resin 11C. The diode structure 12 is formed on a lower face (first face) 11b of the parallel-plate 11A. A lower face (third face) of the transparent member 11B is closely contacted on an upper face (second face) of the parallel-plate 11A via an adhesive, and an upper face (fourth face) 11a of the transparent member 11B is slanted with respect to the lower face 14a of the p-type semiconductor layer 14 among respective faces of the diode structure 12 opposite to the transparent substrate 11.

By such a configuration of the modified example, substantially the same effect as the above-mentioned first embodiment can be obtained. Furthermore, since the sapphire plate which is difficult to be worked is made a parallel-plate, and the slanted face is formed by the acrylic resin or the like which is relatively easy to be worked, it is possible to reduce the working cost of the transparent substrate 11, even though the manufacturing processes are increased. As a material of the transparent member 11B, glass, silicone resin, or another transparent material can be used instead of the acrylic resin.

Furthermore, as a method for fixing the transparent member 11B in this modified example, it is possible to fill a silicone resin 18 around the light emitting device 10 after fixing it on the mounting substrate 17, as shown, for example, in FIG. 4. Still furthermore, the method for mounting the transparent member 11B is not limited to this, so that a method, by which it is mounted on the parallel-plate 11A in optically closely contacted situation, shows the same effect.

Second Embodiment

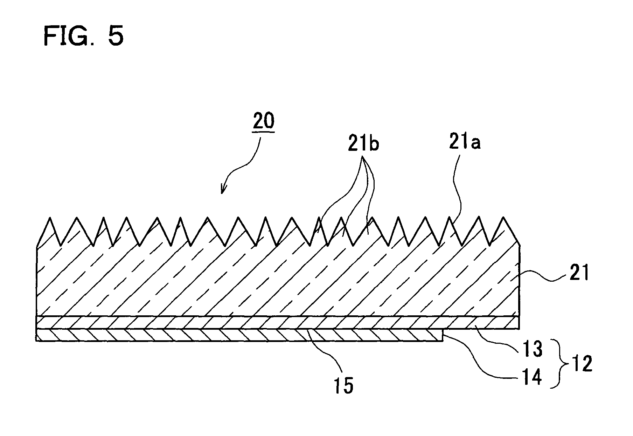

Subsequently, a second embodiment of the present invention is described. In the above-mentioned first embodiment, the exit face (upper face) 11a of the transparent substrate 11 is slanted with respect to the lower face 14a of the p-type semiconductor layer 14. In a light emitting device 20 in accordance with the second embodiment, a lot of convex portions 21 b is formed so that an exit face (upper face) 21a of a transparent substrate 21 becomes rough, as shown in FIG. 4 (SIC: correctly FIG. 5). As a result, the surfaces of respective convex portions 21 b become not in parallel with a face opposite to the transparent substrate 11 (SIC: correctly 21) among respective faces of a diode structure 12, that is, a lower face 14a of a p-type semiconductor layer 14. Since the configuration except the exit face 21 a of the transparent substrate 21 is substantially the same as that in the above-mentioned first embodiment, the same symbols are applied to the same elements, and the description of them is omitted. Furthermore, though it is omitted in FIG. 4 (SIC: correctly FIG. 5), bump electrodes are respectively provided on faces of the n-type semiconductor layer 13 and the p-type semiconductor layer 14 opposite to the transparent substrate 11, and the light emitting device is mounted on a mounting substrate in a face down situation with using the bump electrodes. With respect to these points, they are substantially the same in other embodiments unless otherwise stated.

As can be seen from FIG. 4 (SIC: correctly FIG. 5), cross-sectional shapes of respective convex portions 21 b formed on the exit face 21a of the transparent substrate 21 are formed as a wedge shape that front end thereof is aculeate, and the shapes are not even. It is possible that the shapes and the arrangement of the convex portions 21 b are at random, or that the convex portions 21 b are periodically formed at a predetermined pattern of a plurality of shapes previously set.

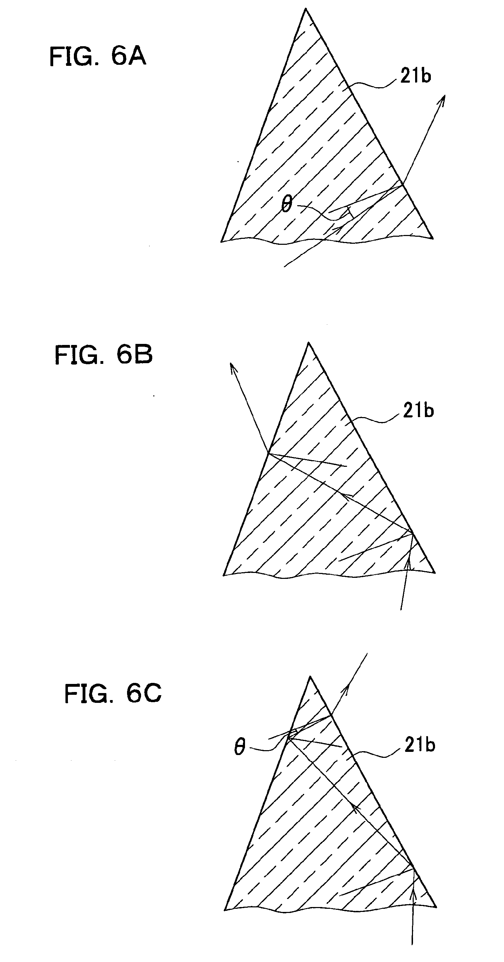

Hereupon, a case that a light beam generated on a pn-composition face 15 enters into the convex portion 21b formed on the exit face 21a of the transparent substrate 21 is described. A light beam, having an incident angle θ with respect to a surface of the convex portion 21b smaller than a critical angle among the incident light beams, is directly emitted outward from the surface of the convex portion 21b, as shown in FIG. 6A. On the other hand, a light beam, having an incident angle θ with respect to the surface of the convex portion 21b smaller than the critical angle, is totally reflected on the surface of the convex portion 21b, and proceeds in the convex portion 21b. The cross-sectional shape of the convex portion 21b, however, is the wedge shape that the front end thereof is aculeate, so that the light beam is reflected on the surface of the convex portion 21b so as to proceed in the convex portion 21b toward the top end, as shown in FIG. 6B or FIG. 6C. Then, the incident angle with respect to the surface of the convex portion 21b is made smaller at each total reflection on the surface of the convex portion 21b, and approaches to 0 degree, that is, the perpendicular. Finally, the incident angle becomes smaller than the critical angle, so that it is emitted outward from the surface of the concave portion 21b. Accordingly, the light taking efficiency can be increased, even though the light emitting device 20 is not sealed by a resin, similar to the case of the first embodiment.

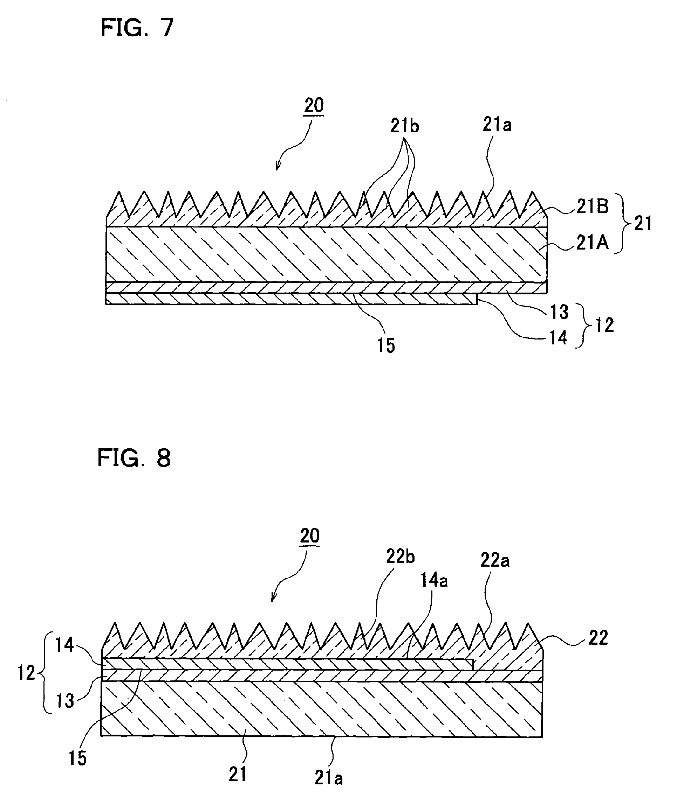

Subsequently, a modified example of the light emitting device 20 in accordance with the second embodiment is shown in FIG. 7. In this modified example, the transparent substrate 21 is constituted by a parallel-plate 21A made of, for example, sapphire, and a transparent member 21B formed on the parallel-plate 21A by spreading a resin such as an epoxy resin having transparency and a high refraction index. Furthermore, a lot of convex portions 21b are formed on a surface of the transparent member 21B so as to make the exit face 21a rough. The other configuration including the convex portions 21b is substantially the same as that in the above-mentioned case shown in FIG. 5, so that the description of them are omitted.

Hereupon, the refraction index of sapphire is about 1.77, and the refraction index of the epoxy resin is about 1.53, so that the difference between them is small. Thus, the critical angle on a boundary face of the parallel-plate 21 A and the transparent member 21B becomes larger about 120 degrees, so that most of the light generated on the pn-composition face 15 enters into the transparent member 21B through the parallel-plate 21A. Then, the light beams entering into the transparent member 21B further enter into the convex portions 21 b provided on the exit face 21a of the transparent member 21B. Behavior of the light beams entering into the convex portions 21b is the same as shown in FIG. 6A to FIG. 6C.

Furthermore, another modified example of the light emitting device 20 in accordance with the second embodiment is shown FIG. 8. In this modified example, the light emitting device 20 is mounted on a mounting substrate in a face up situation. A transparent member 22 is formed on a surface 14a of a p-type semiconductor layer 14 by spreading a resin such as an epoxy resin having transparency and a high refraction index, and a lot of convex portions 22b are formed on a surface of the transparent member 22 so as to make an exit face 22a rough. A cross-sectional shape of each convex portion 22b is formed as a wedge shape that a top end thereof is aculeate. Both faces of the transparent substrate 21 are in parallel with each other.

By such configurations of these modified examples, since the sapphire plate which is difficult to be worked is made a parallel-plate, the transparent member is formed by spreading the epoxy resin or the like which is relatively easy to be worked, and the surface is made rough by forming a lot of the convex portions, it is possible to reduce working cost of the transparent substrate 21, even though the manufacturing processes are increased. As a material of the transparent member, silicone resin or another transparent material can be used instead of the epoxy resin. Furthermore, as a material of the parallel-plate or the transparent substrate, glass, acrylic resin, or the like can be used instead of sapphire.

Third Embodiment

Subsequently, a third embodiment of the present invention is described. In the above-mentioned first embodiment, the upper face 11a of the transparent substrate 11 is slanted with respect to the lower face 11b, and in the second embodiment, the upper face 21a of the transparent substrate 21 is made rough. In the third embodiment, a transparent substrate 31 is made as a polygonal pyramid shape, a circular cone or a substantially hemisphere shape.

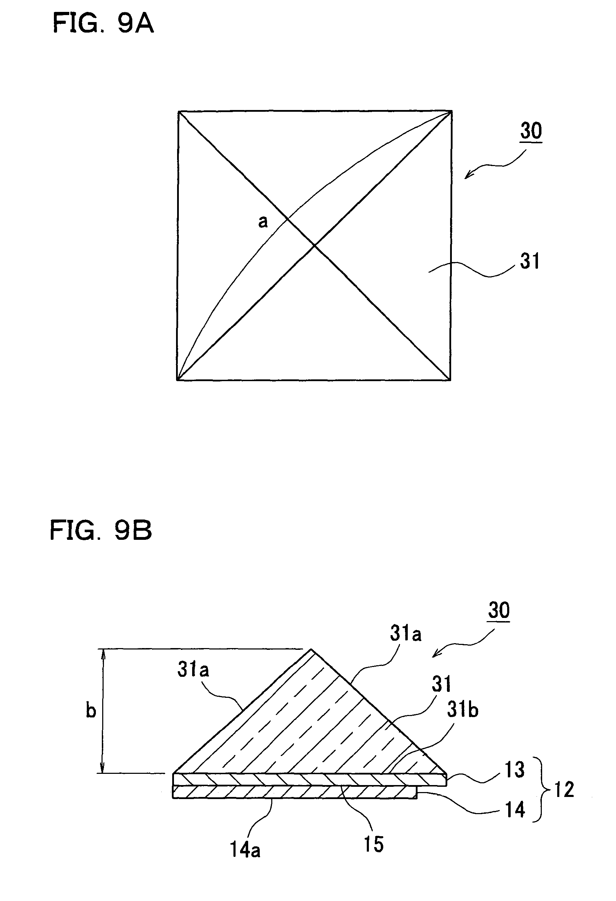

FIG. 9A and FIG. 9B show a first example of configuration of a light emitting device 30 in accordance with the third embodiment. In the first example of configuration, a transparent substrate 31 made of a single material such as sapphire has a regular quadrangular pyramid shape, and a diode structure 12 consisting of lamination of an n-type semiconductor layer 13 and a p-type semiconductor layer 14 is provided on a bottom face thereof. The configuration except the shape of the transparent substrate 31 is substantially the same as that in the above-mentioned first embodiment.

By forming the transparent substrate 31 as the regular quadrangular pyramid shape, four slanted faces serving as exit faces 31a are respectively slanted with respect to a lower face 14a of a p-type semiconductor layer 14, so that the light taking efficiency can be increased, as described in the above-mentioned first embodiment.

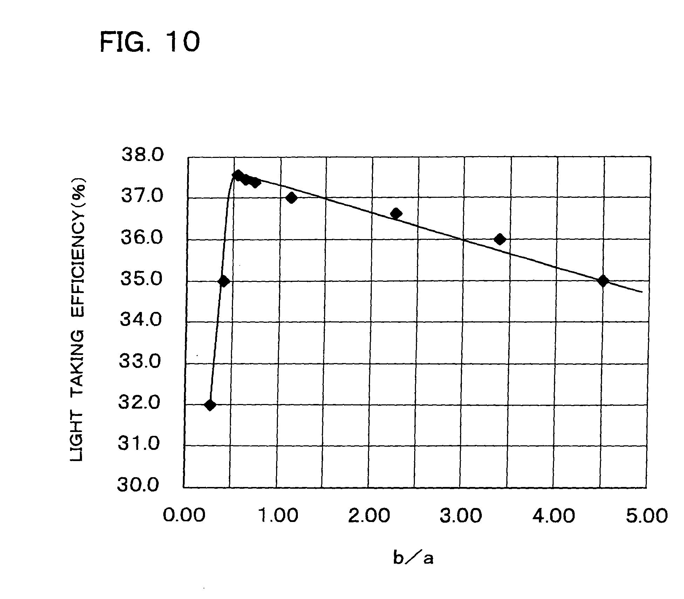

Since a slant angle of the exit faces 31a are varied corresponding to a ratio (b/a) of a height "b" with respect to a maximum width of a bottom face 31 b of the transparent substrate 31 (that is, a length "a" of a diagonal line of the bottom face 31b), it is possible to vary the light taking efficiency by changing the ratio (b/a) of the height "b" with respect to the length "a" of the diagonal line of the bottom face 31b. FIG. 10 shows results of the light taking efficiencies obtained by changing the ratio (b/a). From the results, when the ratio (b/a) is set to a value equal to or larger than about 0.4 and equal to or smaller than about 4.5, the light taking efficiency becomes equal to or larger than about 35%, which is a value larger time and a half of the light taking efficiency of the conventional light emitting device (about 22 to 23%). For example, when the transparent substrate 31 has the regular quadrangular pyramid shape, a length of a bottom side is 350 μm (that is, the length "a" of the diagonal line is 495 μm), and a height "b" is 300 μ m, the ratio of the height "b" with respect to the length "a" of the diagonal line becomes about 0.6, so that the largest efficiency of the light taking efficiency about 37.5% can be obtained.

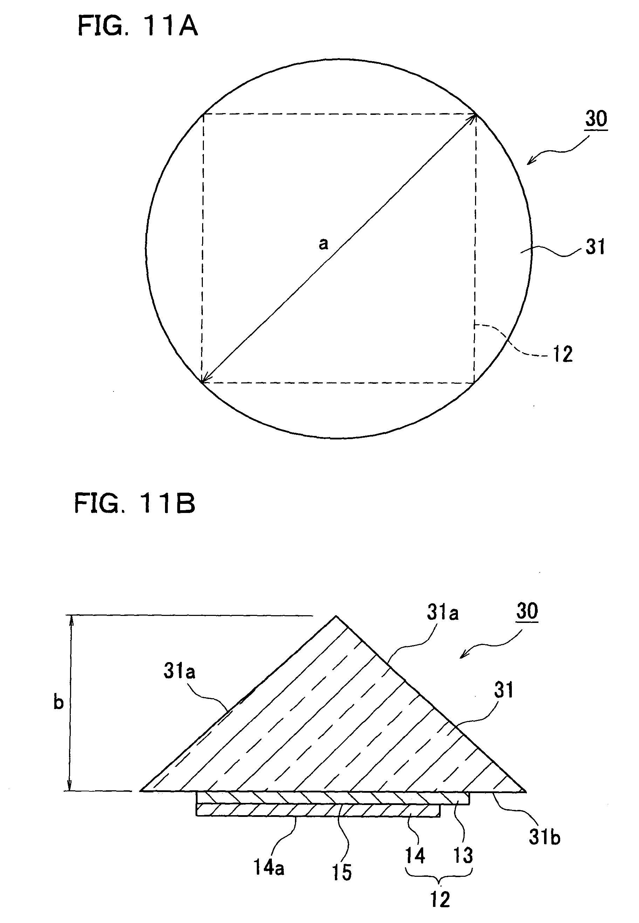

FIG. 11A and FIG. 11B show a second example of configuration of the light emitting device 30 in accordance with the third embodiment. In the second example of configuration, a transparent substrate 31 made of a single material such as sapphire has a circular cone shape. In this case, a diode structure 12 consisting of lamination of an n-type semiconductor layer 13 and a p-type semiconductor layer 14 is provided circumscribing on a bottom face thereof. By setting a height "b" with respect to a diameter "a" of a bottom face of the circular cone shaped transparent substrate 31, similar to the above-mentioned case of the regular quadrangular pyramid, a light taking efficiency can be increased.

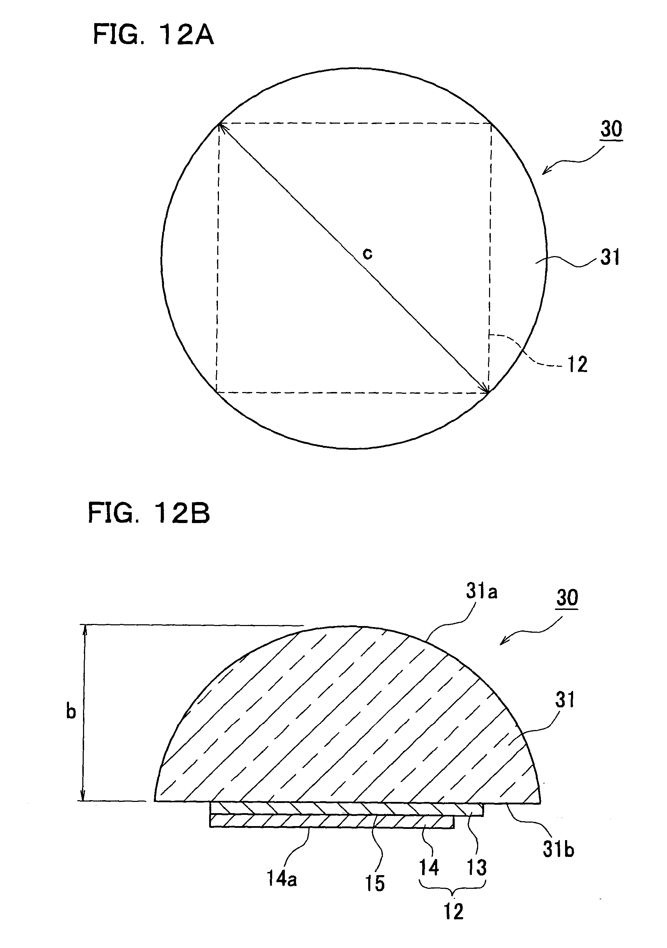

FIG. 12A and FIG. 12B show a third example of configuration of the light emitting device 30 in accordance with the third embodiment. In the third example of configuration, a transparent substrate 31 made of a single material such as sapphire has a substantially hemisphere shape (substantially spherical shape). When the transparent substrate 31 is formed substantially hemisphere, like this, the spherical surface serving as an exit face 31a is slanted with respect to a lower face 14a of the p-type semiconductor layer 14, so that a light taking efficient can be increased, as described in the above-mentioned first embodiment.

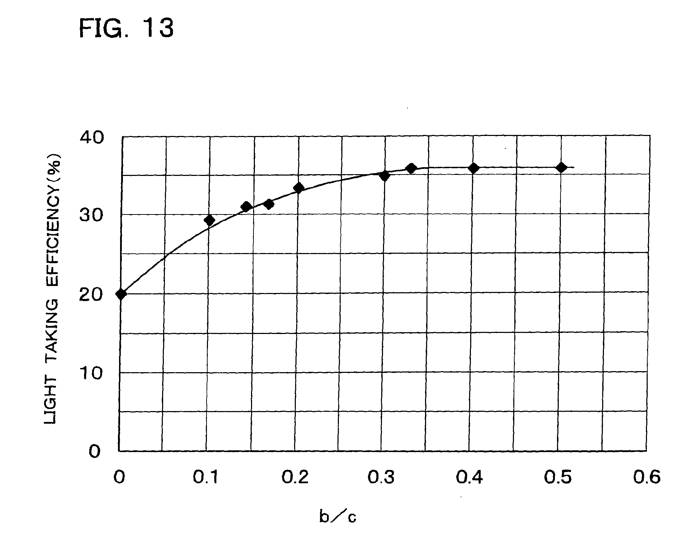

Since a gradient of the exit face 31a is varied corresponding to a ratio (b/c) of a height "b" with respect to a maximum width of a bottom face 31 b of the transparent substrate 31 (that is, a diameter "c" of the bottom face), it is possible to vary the light taking efficiency by changing the ratio (b/c) of the height "b" with respect to the diameter "c" of the bottom face 31b. FIG. 13 shows results of the light taking efficiencies obtained by changing the ratio (b/c). From the results, when the ratio (b/c) is set to a value equal to or larger than about 0.3, the light taking efficiency equal to or larger than about 35% can be obtained. Furthermore, it is found that the largest efficiency about 36% of the light taking efficiency can be obtained by setting the ratio (b/c) to about 0.5. For example, when the diode structure 12 is formed square with a side of 350 μm, and the diameter "c" of the bottom face 31b is selected in a manner so that the diode structure 12 is inscribed with the bottom face 31b, the diameter "c" of the bottom face 31b becomes about 495 μm. When a height "b" of the transparent substrate 31 is about 165 μm, the ratio with respect to the diameter "c" of the bottom face 31b becomes about 0.3, so that the light taking efficiency can be made sufficiently higher value in comparison with that of the conventional light emitting device.

Table 1 shows results of the light taking efficiencies obtained by optical simulations when the size of the diode structure 12 is made a square side of which is 350 μm, and the shape and the height of the transparent substrate 31 are varied. Boxes designated by symbols No. 1 to No. 3 show the results of simulation that the transparent substrate 31 is formed rectangular solid shape (equivalent to the conventional transparent substrate 10 in which the upper face and the lower face are in parallel with each other, as shown in FIG. 55), and the height thereof is varied. Boxes designated by symbols No. 4 to No. 9 show the results of simulation that the transparent substrate 31 is formed pyramid or cone shape, and the height thereof is varied. Boxes designated by symbols No. 10 to No. 13 show the results of simulation that the transparent substrate 31 is formed substantially hemisphere (substantially spherical) shape, and the height thereof is varied.

Table 1

| No | Shape of Substrate | Height(μm) | Light Taking Efficiency(%) |
|----|--------------------|------------|----------------------------|
| 1 | Rectangular Solid | 70 | 22 |
| 2 | | 140 | 22 |
| 3 | | 280 | 22 |
| 4 | Pyramid or Cone | 35 | 24 |
| 5 | | 70 | 28 |
| 6 | | 140 | 30 |
| 7 | | 280 | 36 |
| 8 | | 560 | 38 |
| 9 | | 1120 | 36 |
| 10 | Hemisphere | 70 | 31 |
| 11 | | 82.5 | 32 |
| 12 | | 165 | 36 |
| 13 | | 247.5 | 36 |

As can be seen from the table 1, though the light taking efficiency in case of shaping the transparent substrate 31 as rectangular solid shape is 22%, the light taking efficiency in case of shaping the transparent substrate 31 as pyramid or cone shape becomes up to 38%, so that the light taking efficiency can be increased. Furthermore, the light taking efficiency in case of shaping the transparent substrate 31 as hemisphere shape becomes up to 36%, it, however, is possible to obtain the light taking efficiency substantially the same level when the height of the transparent substrate is lowered in comparison with the case of shaping the pyramid or cone shape.

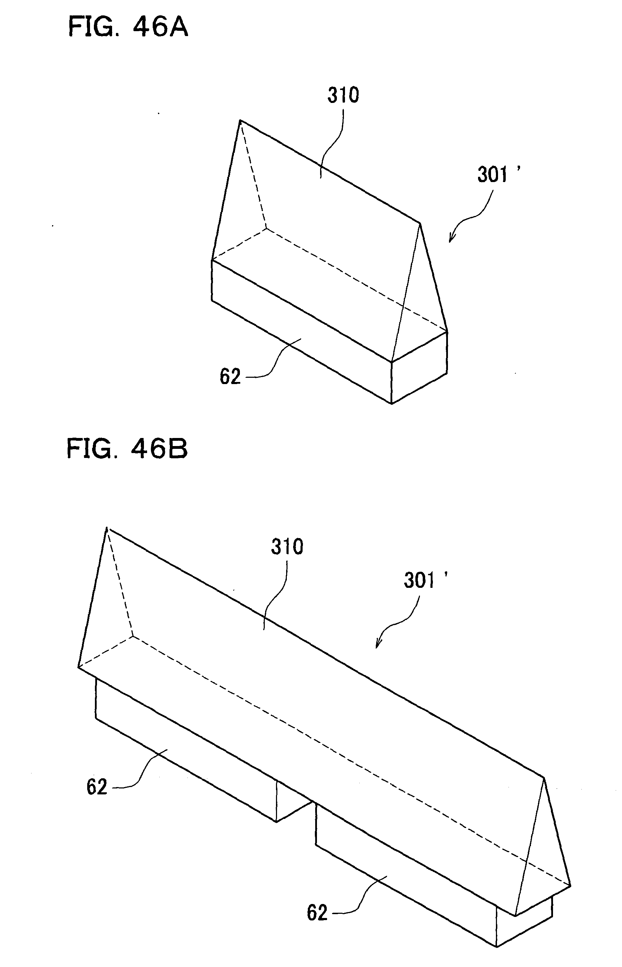

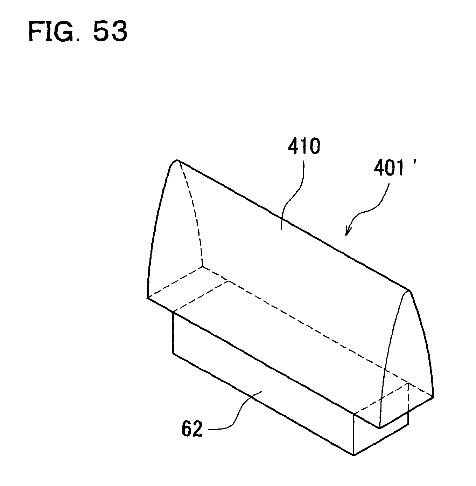

In the third embodiment, the transparent substrate 31 is shaped polygonal pyramid, circular corn or substantially hemisphere, it, however, is not limited to shape the transparent substrate 31 as these. It is possible that the exit face of the transparent substrate is not in parallel with its incident face (bottom face) such as a triangular prism (combination of a plurality of slanted faces), for example, shown in FIG. 46A, or a cylindrical lens shape shown in FIG. 53, which will be described below.

Fourth Embodiment

Subsequently, a fourth embodiment of the present invention is described. In the above-mentioned third embodiment, the single material such as sapphire is formed to be polygonal pyramid, circular cone or substantially hemisphere for the transparent substrate 31. In the fourth embodiment, a transparent substrate 41 is configured by a parallel plate 41 A made of sapphire, or the like and a transparent member 41B of polygonal pyramid, circular cone or substantially hemisphere shape formed on the parallel plate 41 A and made of a material such as epoxy resin, silicone resin, or the like substantially transparent and having a high refraction index.

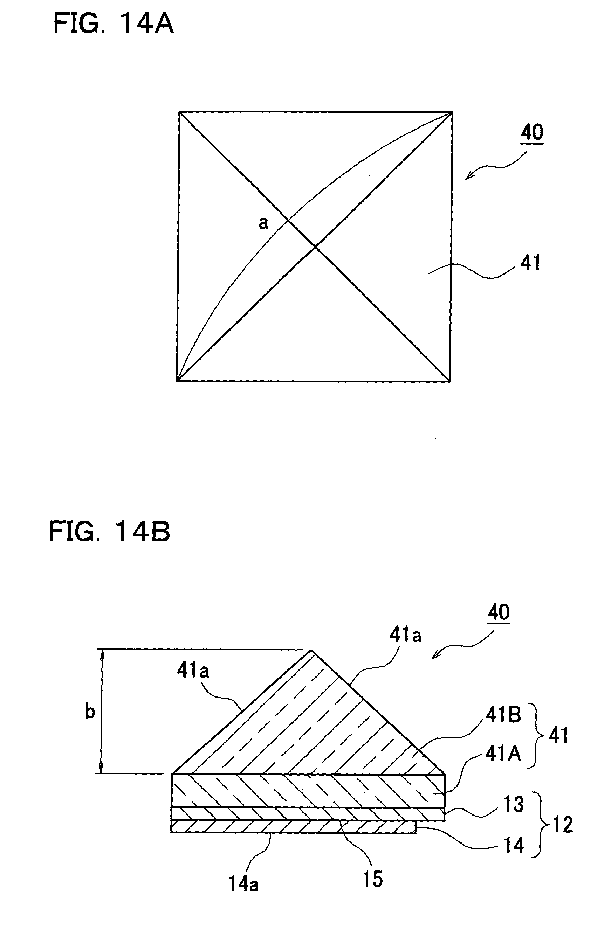

FIG. 14A and FIG. 14B show a first example of configuration of a light emitting device 40 in accordance with the fourth embodiment. In the first example of configuration, as the transparent substrate 41, the parallel plate 41A is formed substantially rectangular solid that an upper face and a bottom face are in parallel with each other and a cross-section in a horizontal direction is square, and the transparent member 41B is formed regular quadrangular pyramid. Furthermore, a diode structure 12 consisting of an n-type semiconductor layer 13 and a p-type semiconductor layer 14 is provided on a bottom face of the parallel plate 41 A.

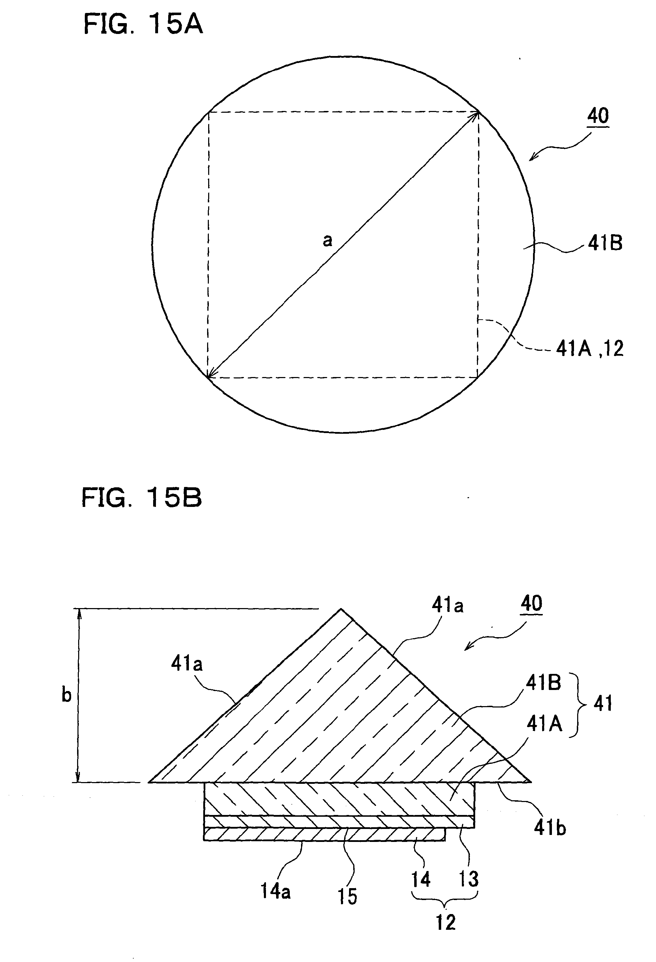

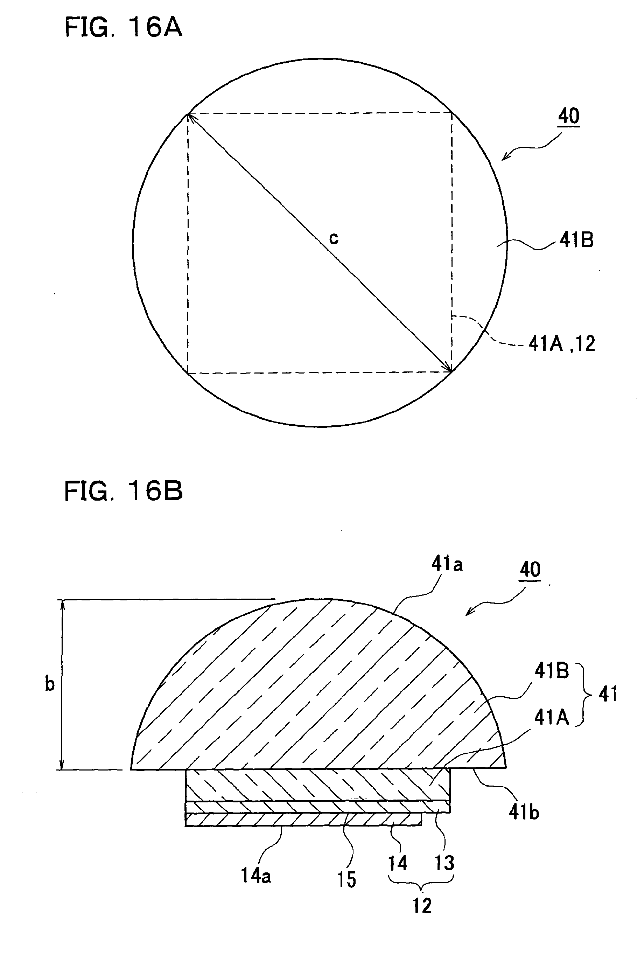

In a second example of configuration shown in FIG. 15A and FIG. 15B, the transparent member 41B is formed as circular cone. In a third example of configuration shown in FIG. 16A and FIG. 16B, the transparent member 41B is formed substantially hemisphere (substantially spherical shape).

According to the fourth embodiment, since the sapphire plate which is difficult to be worked is made a parallel-plate, and the transparent member 41B is formed as the polygonal pyramid, circular cone or substantially hemisphere by epoxy resin or the like which is relatively easy to be worked, it is possible to reduce working cost of the transparent substrate 41, even though the manufacturing processes are increased.

Table 2 shows results of the light taking efficiencies obtained by optical simulations when the shape and the height of the transparent substrate 41 are varied under the same condition as that in the above-mentioned table 1. Boxes designated by symbols No. 1 to No. 3 show the results of simulation that the transparent member 41B of the transparent substrate 41 is formed rectangular solid shape, and the height thereof is varied. Boxes designated by symbols No. 4 to No. 7 show the results of simulation that the transparent member 41B of the transparent substrate 41 is formed pyramid or cone shape, and the height thereof is varied. Boxes designated by symbols No. 8 to No. 11 show the results of simulation that the transparent member 41B of the transparent substrate 41 is formed substantially hemisphere (substantially spherical) shape, and the height thereof is varied.

Table 2

| No | Shape of Substrate | Height(μm) | Light Taking Efficiency(%) |
|---|---|---|---|
| 1 | Rectangular Solid | 70 | 23 |
| 2 | | 140 | 23 |
| 3 | | 280 | 23 |
| 4 | Pyramid or Cone | 140 | 32 |
| 5. | | 280 | 38 |
| 6 | | 560 | 37 |
| 7 | | 1120 | 37 |
| 8 | Hemisphere | 70 | 32 |
| 9 | | 82.5 | 35 |
| 10 | | 165 | 36 |
| 11 | | 247.5 | 36 |

As can be seen from the table 2, though the light taking efficiency in case of shaping the transparent member 41B as rectangular solid shape is 23%, the light taking efficiency in case of shaping the transparent member 41B as pyramid or cone shape becomes up to 38%, so that the light taking efficiency can be increased. Furthermore, the light taking efficiency in case of shaping the transparent member 41B as hemisphere shape becomes up to 36%, it, however, is possible to obtain the light taking efficiency substantially the same level when the height of the transparent substrate is lowered in comparison with the case of shaping the pyramid or cone shape.

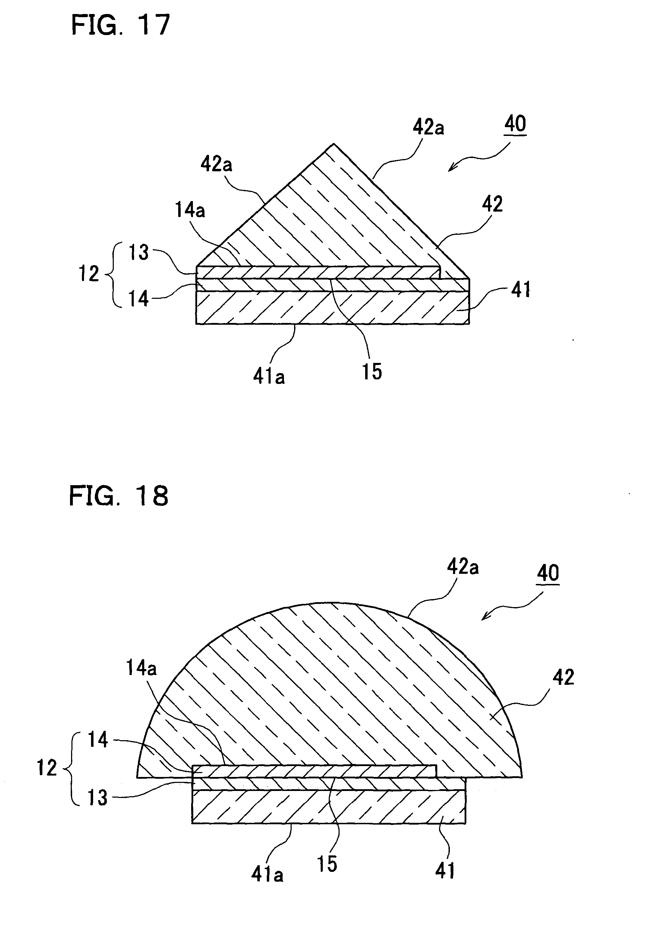

Furthermore, modified examples of the light emitting device 40 in accordance with the fourth embodiment are shown in FIG. 17 and FIG. 18. Since these modified examples are to be mounted on a mounting substrate in a face up situation, a transparent member 42 is provided on a surface 14a of the P-type semiconductor layer 14 by spreading a resin such as epoxy resin having transparency and a high refraction index. In FIG. 17, the transparent member 42 is formed as a polygonal pyramid shape or a circular cone shape. Alternatively, in FIG. 18, the transparent member 42 is formed as a substantially hemisphere shape.

Table 3 shows results of the light taking efficiencies obtained by optical simulations when the shape and the height of the transparent member 42 are varied under the same condition as that in the above-mentioned table 1. Boxes designated by symbols No. 1 to No. 3 show the results of simulation that the transparent member 42 is formed rectangular solid shape, and the height thereof is varied. Boxes designated by symbols No. 4 to No. 9 show the results of simulation that the transparent member 42 is formed pyramid or cone shape, and the height thereof is varied. Boxes designated by symbols No. 10 to No. 13 show the results of simulation that the transparent member 42 is formed substantially hemisphere (substantially spherical) shape, and the height thereof is varied.

Table 3

| No | Shape of Substrate | Height (μm) | Light Taking Efficiency(%) |
|---|---|---|---|
| 1 | Rectangular Solid | 70 | 23 |
| 2 | | 140 | 23 |
| 3 | | 280 | 23 |

Table 3   (continued)

| No | Shape of Substrate | Height (μm) | Light Taking Efficiency(%) |
|---|---|---|---|
| 4 | Pyramid or Cone | 35 | 23 |
| 5 | | 70 | 24 |
| 6 | | 140 | 26 |
| 7 | | 280 | 30 |
| 8 | | 560 | 31 |
| 9 | | 1120 | 30 |
| 10 | Hemisphere | 70 | 26 |
| 11 | | 82.5 | 27 |
| 12 | | 165 | 31 |
| 13 | | 247.5 | 28 |

As can be seen from the table 3, though the light taking efficiency in case of shaping the transparent member 42 as rectangular solid shape is 23%, the light taking efficiency in case of shaping the transparent member 42 as pyramid or cone shape becomes up to 31%, so that the light taking efficiency can be increased. Furthermore, the light taking efficiency in case of shaping the transparent member 42 as hemisphere shape becomes up to 31%, it, however, is possible to obtain the light taking efficiency substantially the same level when the height of the transparent substrate is lowered in comparison with the case of shaping the pyramid or cone shape.

Fifth Embodiment

Subsequently, a fifth embodiment of the present invention is described. In the above-mentioned third and fourth embodiments, the transparent substrate 31 or 41 is entirely formed as the polygonal pyramid, circular cone or substantially hemisphere shape. In the fifth embodiment, a plurality of convex portions 51a of polygonal pyramid, circular cone or substantially hemisphere shape is formed on an exit face 51a of a transparent substrate 51. Furthermore, in comparison with the second embodiment, it is different at a point that the shape and arrangement of the convex portion formed on the exit face of the transparent substrate has regularity.

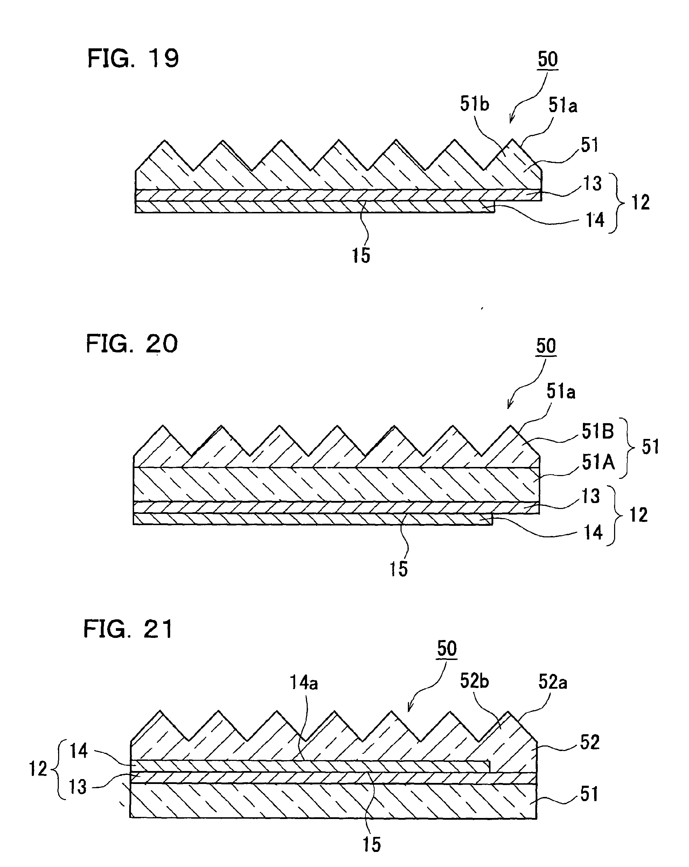

FIG. 19 shows a first example of a light emitting device 50 in accordance with the fifth embodiment. In the first example of configuration, a plurality of the convex portions 51b of, for example, polygonal pyramid such as regular quadrangular pyramid shape, or circular cone shape is regularly arranged on the exit face 51a of the transparent substrate 51. The other configuration is substantially the same as that of the light emitting device 20 of the second embodiment shown in FIG. 4, and the light emitting device 30 of the first example of configuration of the third embodiment shown in FIG. 9A and FIG. 9B.

When it is noticed to each convex portion 51b of the polygonal pyramid shape or the circular cone shape, the description in the above-mentioned third embodiment can be applied without modification, so that it is possible to increase the light taking efficiency can be increased higher in comparison with that of the conventional light emitting device, similar to the case of the third embodiment. Furthermore, when a ratio of a height with respect to a dimension of a diagonal line of each convex portion 51b is the same as that of the case when the transparent substrate is assumed as a single pyramid or cone, the height of the convex portion 51b is lowered by just as much the dimension of the diagonal line is shortened. As a result, a height of the light emitting device 50 can be lowered.

In a second example of configuration shown in FIG. 20, a transparent substrate 51 is configured by a parallel-plate 51 made of sapphire or the like, and a transparent member 51B made of a resin such as epoxy resin or silicone resin having transparency and a high refraction index. A plurality of convex portions 51b of polygonal pyramid or circular cone is regularly arranged on an exit face 51a of the transparent member 51B. The other configuration is substantially the same as that of the first example of configuration.

In a third example of configuration shown in FIG. 21, a light emitting device 50 is to be mounted on a mounting substrate in face up situation. A transparent member 52 is provided on a surface 14a of a p-type semiconductor layer 14 by a resin such as epoxy resin having transparency and a high refraction index. A plurality of convex portions 51b of polygonal pyramid or circular cone is regularly arranged on an exit face 52a of the transparent member 52.

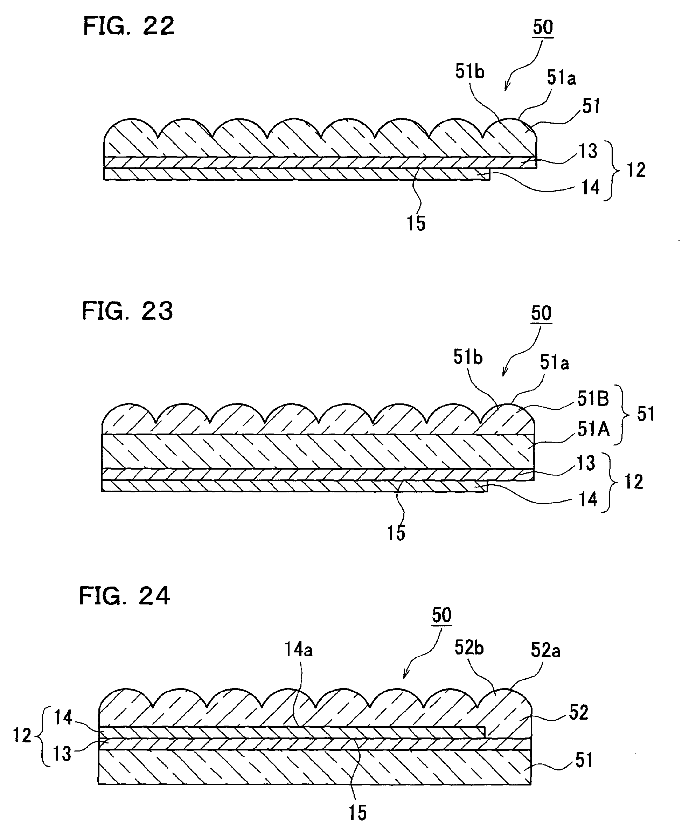

FIG. 22 to FIG. 24 respectively show a fourth to a sixth examples of configuration, which are different from the above-mentioned first to third examples of configuration at a point that a plurality of convex portions 51b or 52b regularly arranged on an exit face 51a of a transparent substrate 51 or on an exit face 52a of a transparent member 52 is formed as substantially hemisphere shape. The other configuration is substantially the same as that in the above-mentioned first to third examples of configuration.

Sixth Embodiment

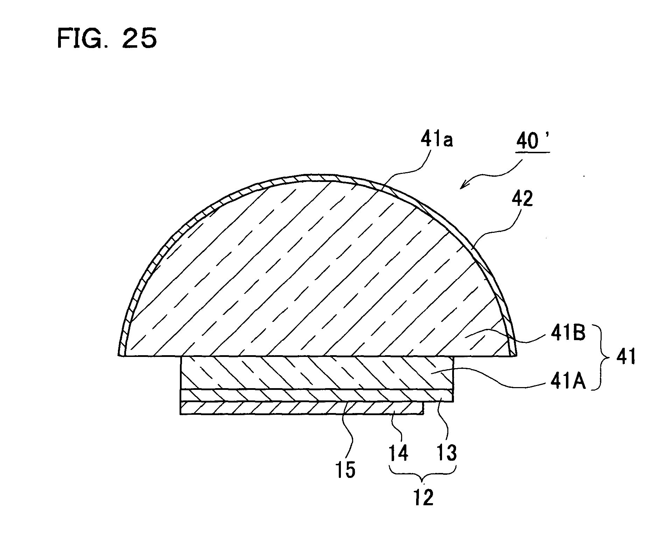

Subsequently, a sixth embodiment of the present invention id described. A light emitting device 40' of the sixth embodiment shown in FIG. 25 is formed an antireflection coating 42 on the light emitting device 40 of the third example of configuration of the fourth embodiment shown in FIG. 16A and FIG. 16B for preventing reflection on a boundary dace between the transparent member 41B and the air medium. Owing to the antireflection coating 42, a light taking efficiency to the air medium can be increased much more. Since other configuration except the antireflection coating 42 is substantially the same as the third example of configuration of the fourth embodiment, the description is omitted.
In case that no antireflection coating is formed, a loss occurs due to occurrence of total reflection on a boundary face of the transparent member 41B and the air medium. In this embodiment, the antireflection coating 42 of a single layer of $MgF_2$ coating having a refraction index about 1.36 is coated on a surface of the transparent member 41B, so that the loss due to reflection occurred on a boundary face between the transparent member 41B and the air medium is reduced. By the way, since it is possible to use optical multiple coating layers as the antireflection coating 42, for example, the antireflection coating 42 is configured by a lamination of layers of $TiO_2$, $SiO_2$ and $Al_2O_3$.
In this embodiment, though the antireflection coating 42 is formed on the exit face 41a of the light emitting device 40 of the fourth embodiment. it is needless to say that the antireflection coating can be formed on an exit face of a light emitting device in accordance withy another embodiment.

Seventh Embodiment

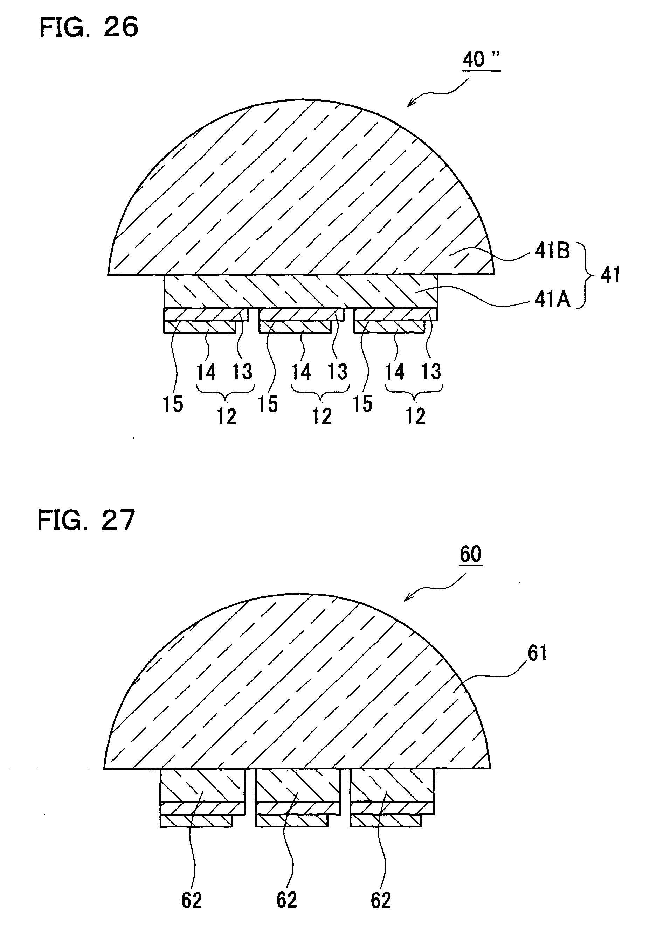

Subsequently, a seventh embodiment of the present invention is described. In the light emitting devices in accordance with the above-mentioned first to sixth embodiments, a single diode structure 12 is formed on a face of a transparent substrate, which is not the exit face thereof, by laminating an n-type semiconductor layer 13 and a p-type semiconductor layer 14. In a light emitting device 40" in accordance with the seventh embodiment shown in FIG. 26, n-type semiconductor layers 13 and p-type semiconductor layers 14 are laminated on a plurality of portions, so that the semiconductor structure 12 is divided into a plurality of portions in substance. The other configuration is substantially the same as that of the above-mentioned third example of configuration in the fourth embodiment, so that the description is omitted. Furthermore, it is omitted to illustrate in the figures, bump electrodes are respectively formed on lower faces of the n-type semiconductor layers 13 and the p-type semiconductor layers 14, and mounted on a mounting substrate in face down situation with using the bump electrodes.
In the configuration that the diode structure 12 is divided into a plurality of portions like the light emitting device 40" in accordance with the seventh embodiment, the bump electrodes are provided on respective divided portions so as to be connected to the mounting substrate, so that thermal conduction paths are increased in substance. As a result, heat radiation performance of heat generated in the light emitting device can be increased, so that an operating life of the light emitting device 40" can be elongated. Furthermore, since the temperature of the light emitting device 40" during light emission becomes lower, a quantity of light emitted from the light emitting device 40" is increased. Still furthermore, areas of the u-type semiconductor layer 13 and the p-type semiconductor layer 14 per a pair of bump electrodes become narrower, so that current density in each divided area is uniformized much more, and unevenness of luminance can be reduced.
In this embodiment, the diode structure 12 of the light emitting device 40 of the fourth embodiment is divided into a plurality of portions. It is needless to say that a diode structure 12 of a light emitting device in accordance with another embodiment can be divided into a plurality of portions.
Alternatively, as shown in FIG. 27, it is possible to dispose a plurality of light emitting units 62 having, for example, substantially the same configuration as that of the conventional light emitting device 100 shown in FIG. 55 closely on a lower face (incident face of light) of a relatively larger single transparent member 51. By disposing an optional number of light emitting units 62 closely on a transparent member 61 in which an exit face of light is not in parallel with an incident face, like this, a light emitting device 60 having an optional light emitting area can be supplied for any purpose. Furthermore, the light taking efficiency can be made higher by the existence of the transparent member 61 than that in the case that a plurality of conventional light emitting devices 100 is merely arranged.

Eighth Embodiment

Subsequently, an eighth embodiment of the present invention is described. The above-mentioned first to seventh embodiments respectively relate to the light emitting device. The eighth embodiment, however, relates to a lighting apparatus using one of the above-mentioned light emitting devices.

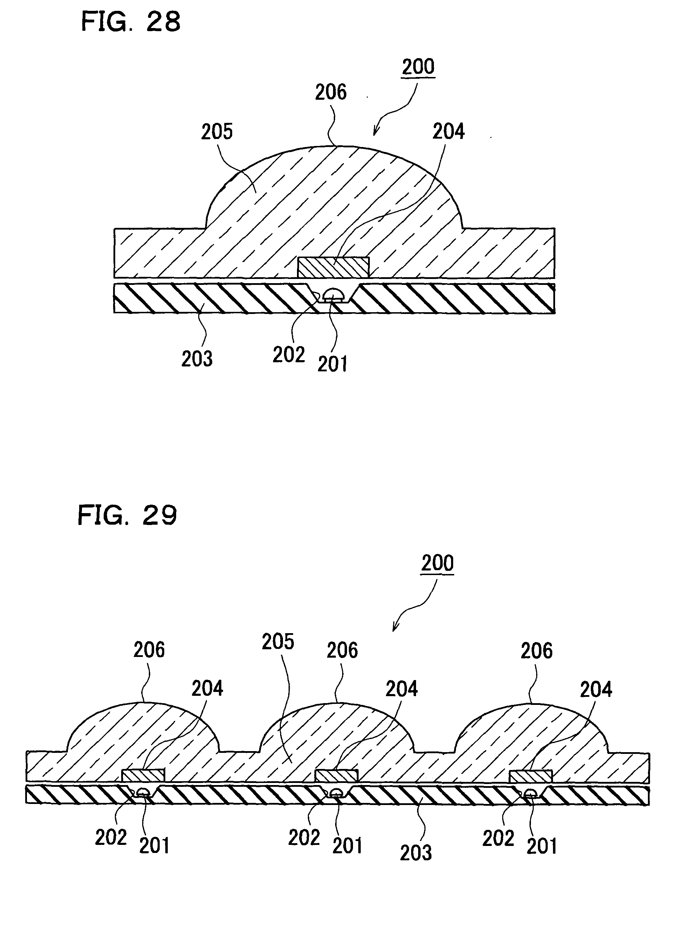

A configuration of a lighting apparatus 200 in accordance with the eighth embodiment is shown in FIG. 28. The lighting apparatus 200 is configured by a mounting substrate 203 having a concave portion 202 in which a light emitting device 201 is mounted, an optical member 205 on which a fluorescent member 204 is provided at a position facing the concave portion 202 (in front of an exit face of light of the light emitting device 201), and so on.

The light emitting device 201 is, for example, a blue light emitting device for emitting a blue light, and it is possible to have any one of the light emitting devices in accordance with the first to eighth (SIC: correctly seventh) embodiments. For mounting the light emitting device 201 in face down situation, it is electrically connected to a circuit on the mounting substrate 203 via, for example, bump electrodes designated by symbols 16a and 16b in FIG. 1.

The fluorescent member 204 includes fluorescent materials, for example, emitting yellow light excited by blue light, which is formed by filling a resin including the fluorescent materials into a concave portion 207 formed on the optical member 205. The fluorescent member 204 is disposed for facing the light emitting device 201 as mentioned above, and a size thereof is set in a manner so that most of the light beams emitted from the light emitting device 201 enters therein. The optical member 205 is made of, for example, a transparent material such as acrylic resin, and a convex lens 206 having a desired shape, or the like is formed on an opposite side to the fluorescent member 204 for controlling distribution of light.

The blue light emitted from the light emitting device 201 enters into the fluorescent member 204, and a part of it excites the fluorescent material so as to generate a light having a different wavelength from that of the incident blue light. Then, for example, a white light is outputted from the lighting apparatus 200 by mixing the blue light passing through the fluorescent member 204 and the lights generated by the fluorescent materials.

Even when the light emitting device 201 emits ultraviolet light, it is possible to output while light by mixing exited lights owing to the fluorescent materials with selecting the kinds of the fluorescent materials, properly.

By disposing the fluorescent member 204 at the nearest position to the light emitting device 201 in the optical member 205, like this, it is possible to enter the light beams emitted from the light emitting device 201 into the fluorescent member 204, effectively. Furthermore, since the optical member 205 which is an individual member from the light emitting device 202 (SIC: correctly 201) is formed to be an optional optical shape and the fluorescent member 204 is provided in the optical member 205, stress, heat or chemical load applied to the light emitting device 201 is reduced.

Furthermore, in order not to contact the fluorescent member 204 with the light emitting device 201, a gap is provided between them, so that the fluorescent member 204 may not be exposed directly by heat from the light emitting device 201, and deterioration of the fluorescent materials, the resin including the fluorescent materials, or the like is reduced. As a result, the operating life of the fluorescent member 204 can be elongated, so that reduction of light flux can be prevented, and the operating life of the lighting apparatus 200 can be elongated. Still furthermore, since the fluorescent member 204 is not contacted with the light emitting device 201, the heat radiation performance of the light emitting device 201 becomes better.

Still furthermore, since the fluorescent member 204 such as fluorescent materials or a resin including the fluorescent materials which are deteriorated quickly is provided on a side of the optical member 205, and the optical member 205 is detachable with respect to the mounting substrate 203, it is possible to renew the fluorescent member 204 by replacing the optical member 205 with a new one when lighting performance of the lighting apparatus 200 is reduced due to the deterioration of the fluorescent member 204. Consequently, it is possible to recover the lighting performance of the lighting apparatus 200 to an initial state.

A modified example of the lighting apparatus in accordance with the eighth embodiment is shown in FIG. 29. As obvious from FIG. 29, in this modified embodiment, a plurality of concave portions 202 are formed on a single mounting substrate 203, light emitting devices 201 are respectively mounted in the concave portions 202, and a plurality of fluorescent members 204 and lenses 206 respectively facing the concave portions 202 are provided on a single optical member 205. By such a modified example, a surface emitting apparatus having substantially the same effect as mentioned above and an enlarged area of a light emitting portion can be obtained.

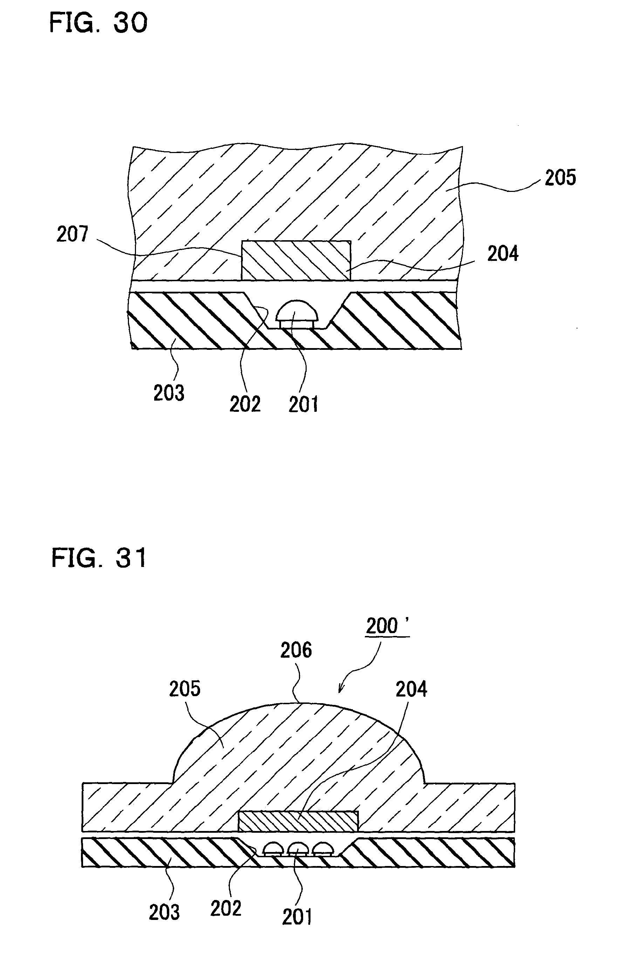

In another modified example of the eighth embodiment shown in FIG. 30, a face of a fluorescent member 204 facing a light emitting device 201 is formed substantially the same size as that of an opening of a concave portion 202 formed on a mounting substrate 203. Specifically, edges of an opening of a concave portion 207 of the optical member 205 and edges of the concave portion 202 of the mounting substrate 203 are formed substantially the same shape so as to be adjusted with each other. When a resin including fluorescent materials is filled in the above-mentioned concave portion 207, the face of the fluorescent member 204 facing the light emitting device 201 becomes the size substantially equivalent to that of the opening of the concave portion 202.

In the case of this modified example, even though accuracy of dimensions of the mounting substrate 205 and the optical member 205 is required, the size of the fluorescent member 204 can be made to be the minimum necessary, so that a quasi-light source as smaller as possible can be obtained. As a result, control of distribution of light becomes easier by selecting a shape of a convex lens 206 of the optical member 205 properly, so that it is possible to realize a desired distribution of light. Furthermore, since the face of the fluorescent member 204 facing the light emitting device 201 is formed substantially the same as that of the opening of the concave portion 202, the blur of outline of the light emitting portion in the fluorescent member 204 is prevented, and the distribution of light is improved.

Subsequently, still another modified example of the eighth embodiment is shown in FIG. 31. In a lighting apparatus 200' in this modified example, a plurality of light emitting devices 201 is closely mounted in a concave portion 202 of a mounting substrate 203. Corresponding to this, the concave portion 202 of the mounting substrate 203 and a fluorescent member 204 of an optical member 205 are upsized. In the case of this modified example, a plurality of light emitting devices 201 is used, so that luminance of the lighting apparatus 200 (SIC: correctly 200') becomes entirely higher. Furthermore, the light emitting devices are disposed for facing a center portion of the fluorescent member 204, so that luminance of the center portion in light emission of the fluorescent member 204 becomes higher. Thus, it becomes near to a point light source, so that a narrower distribution of light can be realized.

Ninth Embodiment

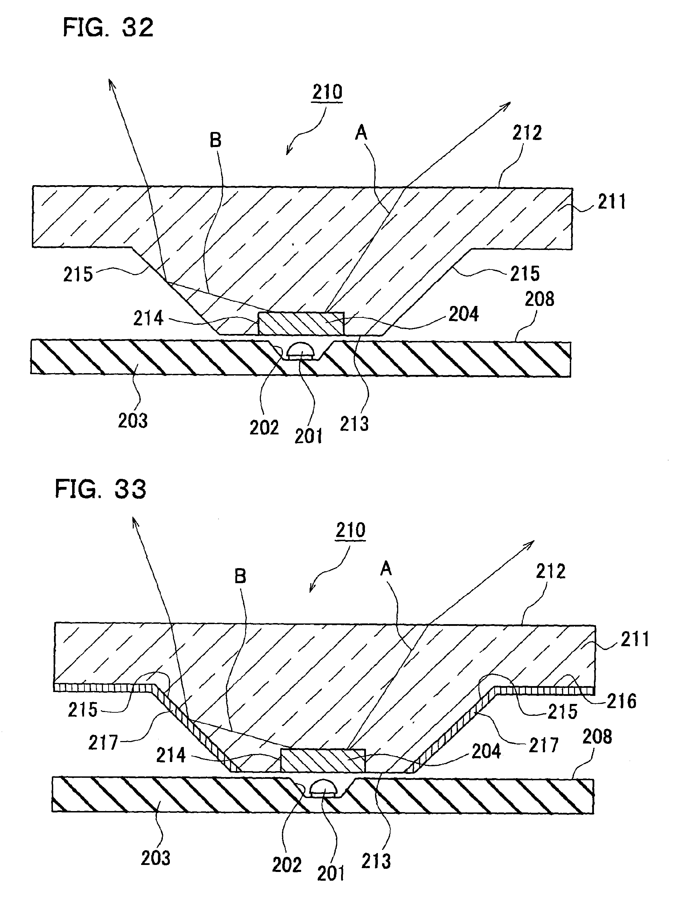

Subsequently, a ninth embodiment of the present invention is described. A configuration of a lighting apparatus 210 in accordance with the ninth embodiment is shown in FIG. 32. The lighting apparatus 210 is configured by a mounting substrate 203 on which a light emitting device 201 is mounted and an optical member 211 on which a fluorescent member 204 is provided. The mounting substrate 203 is substantially the same as that of the lighting apparatus 200 in accordance with the above-mentioned ninth (SIC: correctly eighth) embodiment.

The optical member 211 is configured in a manner to reflect light beams, which are emitted in directions different from directions toward a light taking-out face 212 of the optical member 212 among light beams wavelength of which are converted by and emitted from the fluorescent member 204, to directions toward the light taking-out face 212. Specifically, a concave portion 214 is formed at a position facing the light emitting device 201 on a face 213 opposite to the light taking face 212 of the optical member 211, and the fluorescent member 204 is formed by filling a resin including fluorescent materials in the concave portion 214. Slanted faces 215 are formed on both side of the fluorescent member 204 for totally reflecting the light beams emitted from the fluorescent member 204 in directions different from directions toward the light taking-out face 212 in the directions toward the light taking-out face 212. The light taking-out face 212 is formed in parallel with an upper face 208 of the mounting substrate 203.

Generally, the light beams emitted from the fluorescent member 204 are divided into a group directly moving for the light taking-out face 212 as shown by arrow A in FIG. 31 and a group moving in substantially lateral direction shown by arrow B instead of the light taking-out face 212. The light beam emitted in substantially lateral direction from the fluorescent member 204 is reflected on the slanted face 215 and emitted outward from the light taking-out face 212. As a result, distribution of light emitted from the lighting apparatus 210 can be controlled in predetermined directions.

As shown in FIG. 33, it is possible to provide reflection portions 217 on the slanted faces 215 and rear faces 216 against the light taking-out face 212 by vapor deposition of aluminum, or the like. In such a case, it is needless to say that no reflection portion is formed at least a portion on a face 213 opposite to the light taking-out face 212 of the optical member 211 into which light beams emitted from the light emitting device 211 enters. By providing the reflection portions 217 on the slanted faces 215 and the rear faces 216 of the light taking-out face 212, like this, it is possible to totally reflect all the light beams entering into the slanted faces 215 and the rear faces 216 of the light taking-out face 212, and it is possible to prevent the leakage of light beams to a side of the mounting substrate 203 from these faces. The light emitting efficiency can be increased much more. Furthermore, since the reflection portions 217 are provided between the optical member 211 and the mounting substrate 203, it cannot be touched easily, and it is possible to reduce the deterioration or the dirt of the reflection portions.

Tenth Embodiment

Subsequently, a tenth embodiment of the present invention is described. The tenth embodiment relates to a convex portion 202 of a mounting substrate 203 in which a light emitting device 201 is mounted. With respect to the optical member, it is possible to use any one in the above-mentioned eighth and ninth embodiments, alternatively, it is possible to use another shaped one.

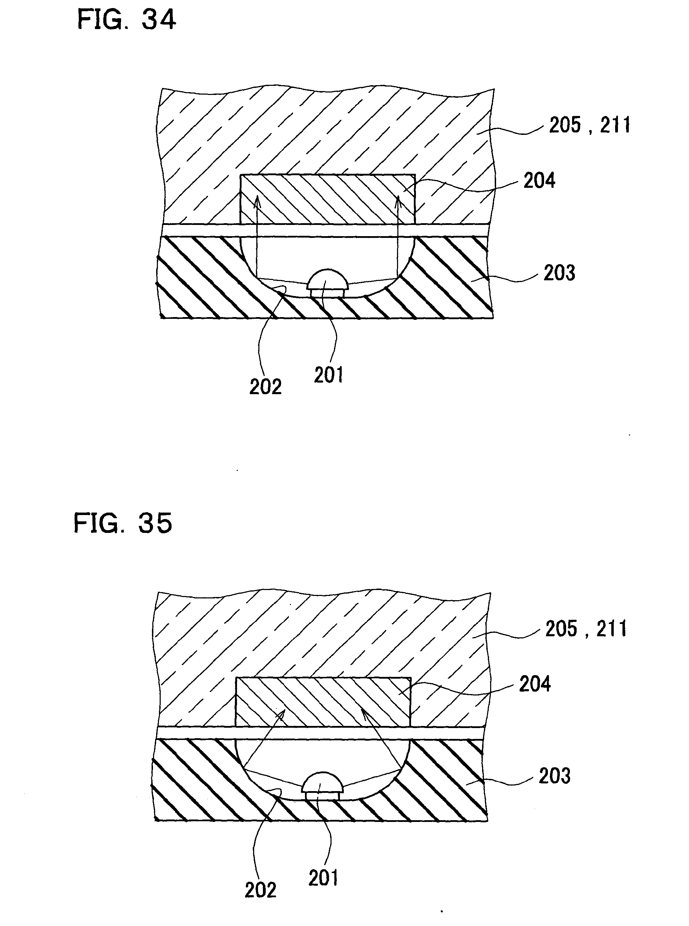

In a first example of configuration of the tenth embodiment shown in FIG. 34, an inside face of the concave portion 202 provided on the mounting substrate 203 is formed substantially parabolic shape. By such a configuration, a part of the light beams emitted from the light emitting device 201 is reflected on the substantially parabolic shaped inside face of the convex portion 202, and entered into the fluorescent member 204 as substantially parallel beams as shown by arrows in FIG. 34. As a result, quantity of light entering into the fluorescent member 204 can be increased, and distribution of emission of light in the fluorescent member 204 can be uniformized. Consequently, it is possible to reduce color heterogeneity on a light taking-out face of the lighting apparatus.

In a second example of configuration of the tenth embodiment shown in FIG. 35, an inside face of the concave portion 202 provided on the mounting substrate 203 is formed substantially ellipsoidal shape. By such a configuration, a part of the light beams emitted from the light emitting device 201 is reflected on the substantially ellipsoidal shaped inside face of the convex portion 202, and entered into the fluorescent member 204 as substantially parallel beams as shown by arrows in FIG. 35. As a result, quantity of light entering into the fluorescent member 204 can be increased, and the light beams can be concentrated in a center portion of the fluorescent member 204, so that the fluorescent member 204 can be downsized. Consequently, it becomes near to a point light source, so that a narrower distribution of light can be realized.

Eleventh Embodiment

Subsequently, an eleventh embodiment of the present invention is described. The eleventh embodiment relates to a method for fixing a light emitting device 201 in a convex portion 202 of a mounting substrate 203.

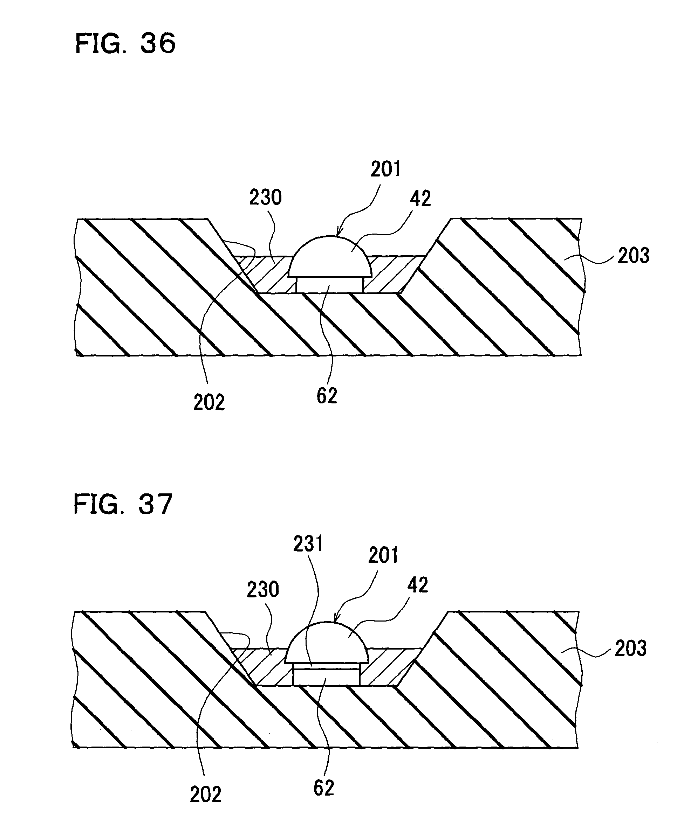

In a first example of configuration of the eleventh embodiment shown in FIG. 36, a light emitting device, which is, for example, substantially the same one as the third example of configuration of the light emitting device 40 in accordance with the fourth embodiment shown in FIG. 16A and FIG. 16B, is used as the light emitting device 201. The light emitting device 40 shown in FIG. 16B has a configuration substantially the same as that of the conventional light emitting device 100 shown in FIG. 55, except the substantially hemisphere shaped transparent member 41B.

Then, the light emitting device 201 is formed by adhering a substantially hemisphere shaped transparent member 42, which is made of a transparent high refraction index material such as acrylic resin on a light emitting unit 62 having substantially the same configuration as that of the conventional one. First, the light emitting unit 62 is mounted in the convex portion 202 of the mounting substrate 203. Subsequently, a transparent resin 230 such as silicone resin having relatively higher refraction index is filled partway in the concave portion 202, and the transparent member 42 is closely disposed on an exit face of the light emitting unit 62 under the condition so that the transparent member is fixed in a state that lower side thereof is steeped into the resin. Thus, the mounting of the light emitting device 201 becomes easier than that in a case that the light emitting device 201 is previously assembled by fixing the transparent member 42 on the light emitting unit 62, and the assembled light emitting device 201 is mounted on the mounting substrate 203. Furthermore, since the resin comes into a gap between the transparent member 42 and the light emitting unit 62, adhesion performance of the transparent member 42 and the light emitting unit 62 is increased, and they are firmly fixed. Still furthermore, a side portion of the light emitting device 201 is sealed by the resin having relatively higher refraction index, so that the light taking efficiency from the side portion of the light emitting device is increased, too.

Still furthermore, when a material, which is the same as the resin (for example, silicone resin) filled in the concave portion 230, is used as a material of the transparent member 42, a boundary face is reduced in substance, so that it is possible to reduce a loss due to Fresnel reflection. Still furthermore, since the adhesion performance of the transparent member 42 and the light emitting unit 62 is increased, a light taking efficiency on the boundary is increased, and strength for fixing the transparent member 42 is increased.

In a second example of configuration of the eleventh embodiment shown in FIG. 37, a transparent interlayer 231, which is made of a material having an intermediate refraction index $n_1$ between a refraction index $n_2$ of a material of a transparent member 42 and a refraction index $n_0$ of a material of a transparent substrate of a light emitting unit 62 (see, for example, the transparent substrate 101 in FIG. 55), is provided between the transparent member 42 and the light emitting unit 62, and the transparent member 42 is fixed by filling a resin 230 such as silicone resin having relatively higher refraction index halfway into a concave portion 202. For example, when it is assumed that the material of the transparent substrate of the light emitting unit 62 is sapphire (refraction index $n_0$=1.77), and the material of the transparent member 42 is acryl (refraction index $n_1$=1.49), the transparent interlayer 231 is formed by a material satisfying a condition of $1.77>n_1>1.49$. In such a case, since the transparent member 42 is fixed by the resin 230, the material of the transparent interlayer 231 does not necessarily have adhesion property.

Subsequently, the reason why the refraction index $n_1$ of the transparent interlayer 231 is selected to an intermittent value between the refraction index $n_2$ of the material of the transparent member 42 and the refraction index $n_0$ of the material of the transparent substrate of the light emitting unit 62 is described. With respect to the refraction indexes no, $n_1$ and $n_2$, the above-mentioned description of the prior art will be referred, so that the same symbols will be used redundantly.

As described in the prior art, in case that three layers respectively having refraction indexes no, $n_1$ and $n_2$ ($n_0>n_1>n_2$) are serially laminated, a critical angle $\theta_0$ of light from a first layer of the refraction index $n_0$ to a third layer of the refraction index $n_2$ becomes $\theta_0=\sin^{-1}(n_2/n_0)$ with no relation to the refraction index $n_1$ of a second layer. In this case, since the material of the transparent substrate of the light emitting unit 62 corresponding to the first layer is sapphire (no=1.77), and the material of the transparent member 42 corresponding to the third layer is acryl ($n_2$=1.49), the critical angle $\theta_0=\sin^{-1}(n_2/n_0) \fallingdotseq 57$ degrees (first equation).

On the other hand, in case that three layers respectively having refraction indexes $n_0$, $n_1$ and $n_2$ ($n_0>n_2>n_1$)

are serially laminated, no total reflection occurs on a boundary face between the second layer of the refraction index $n_1$ and the third layer of the refraction index $n_2$, and all the light entering into the second layer of the refraction index $n_1$ from the first layer of the refraction index $n_0$ enters into the third layer of the refraction index $n_2$. Accordingly, the critical angle $\theta_0$ of light from the first layer of the refraction index $n_0$ to the third layer of the refraction index $n_2$ is governed by the refraction index $n_0$ of the first layer and the refraction index $n_1$ of the second layer, so that $\theta_0 = \sin^{-1}(n_1/n_0)$ (second equation). In such a case, the smaller the refraction index $n_1$ of the second layer is, the smaller the critical angle $\theta_0$ becomes.

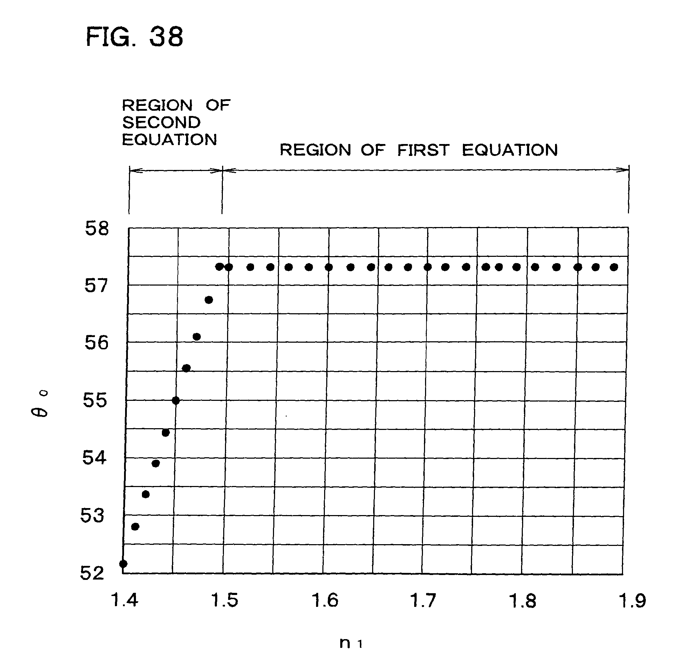

A relation between the refraction index $n_1$ of the transparent interlayer 231 and the critical angle $\theta_0$ is shown in FIG. 38. As can be seen from FIG. 38, when the refraction index $n_1$ of the transparent interlayer 231 is made larger than the refraction index $n_2$ of the transparent member 42, the quantity of light entering into the transparent member 42 becomes the largest. On the other hand, when it is considered that a material having larger refraction index is generally expensive and the loss due to Fresnel reflection is larger, it is preferable to make the refraction index $n_1$ smaller. Accordingly, by selecting the refraction index $n_1$ of the transparent interlayer 231 as an intermediate value between the refraction index $n_2$ of the material of the transparent member 42 and the refraction index $n_0$ of the material of the transparent substrate of the light emitting unit 62, as mentioned above, the light emitted from the light emitting unit 62 can be entered into the transparent member 42 most effectively.

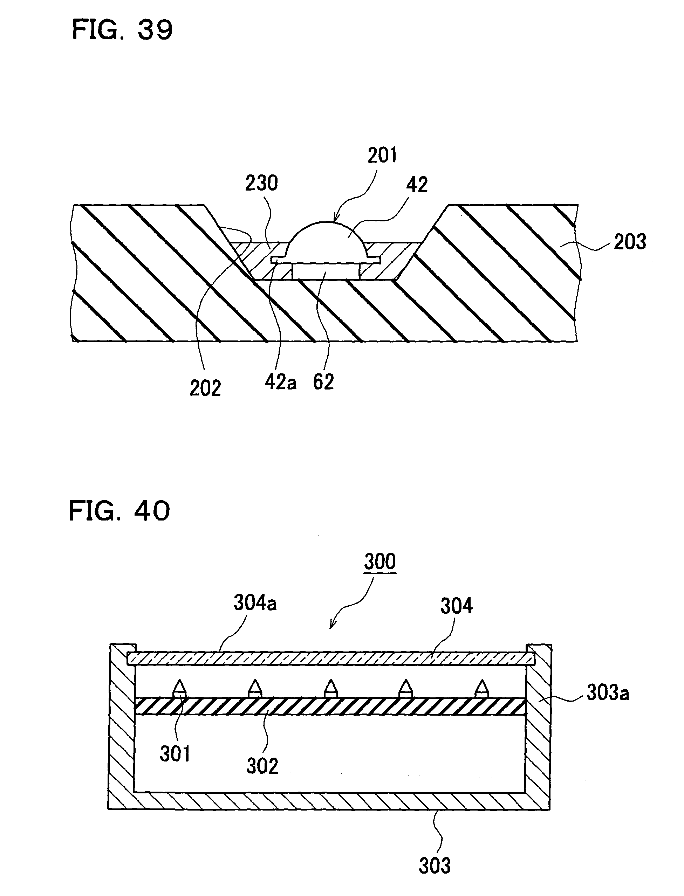

In a third example of configuration shown in FIG. 39, a flange 42a is provided in the vicinity of a bottom of a transparent member 42 for protruding outward from an exit face of light, and a resin 230 is filled in a concave portion 202 in a manner so that the flange 42a is completely embedded in the resin 230. By such a configuration, in comparison with the first example of configuration, though the shape of the transparent member 42 becomes a little complex, contacting area with the resin 230 is increased, so that mechanical strength for fixing the transparent member 42 is increased. Furthermore, it is possible to provide a transparent interlayer having an intermediate refraction index between a refraction index of a material of the transparent member 42 and a refraction index of a material of a transparent substrate of the light emitting unit 62, like the above-mentioned second example of configuration.

Twelfth Embodiment

Subsequently a twelfth embodiment of the present invention is described. The twelfth embodiment relates to a surface emitting illumination apparatus using a plurality of light emitting devices. A first example of configuration of the surface emitting illumination apparatus 300 in accordance with the twelfth embodiment is shown in FIG. 40. In the first example of configuration of the surface emitting illumination apparatus 300, a plurality of light emitting devices 301 is mounted on a mounting substrate 302, and the mounting substrate 302 is held at a substantially center portion of a housing 303. Furthermore, a flat plate fluorescent member 304 is held at a position in the vicinity of an upper end of the housing 303 so as to be substantially in parallel with a mounting face of the mounting substrate 302.

The light emitting device 301 is a light emitting device having a polygonal pyramid shaped or a circular cone shaped transparent substrate or transparent member in accordance with the above-mentioned third or fourth embodiment, and emits, for example, blue light or ultraviolet light. Since the light emitting device 301, however, is not limited to the illustrated shaped one, it is sufficient that a width of a cross-section of an exit face of light in a predetermined direction is made narrower correspondingly departing from a pn-composition face 15 serving as light emitting face of the light emitting device, among the light emitting devices in accordance with the first to seventh embodiments.

The light emitting devices 301 are arranged on the mounting substrate 302 in a manner so that each distance becomes substantially even. A wiring pattern is formed on the mounting substrate 302 in a manner so that a plurality of sets of the light emitting devices 301 connected in series is connected in parallel. The housing 303 is formed substantially cylindrical shape having a bottom of, for example, metal, resin or the like, and having a height of about 20 mm and a diameter of about 50 mm. The mounting substrate 302 is fixed on a side wall 303 of the housing 303 so as to be substantially perpendicular to it at a position substantially in the vicinity of the center of the side wall 303a. The fluorescent member 304 is formed disc shape of a mixture of a transparent material such as acryl with fluorescent materials, and fixed substantially perpendicular to the side wall 303a in the vicinity of the upper end of the side wall 303a of the housing 303 with a gap of about 5 mm with respect to the mounting face of the mounting substrate 302.

By emitting blue light or ultraviolet light from a plurality of the light emitting devices 301 arranged on the mounting substrate 302, and emitting lights having different wavelengths due to excitation of the fluorescent materials of the fluorescent member 304 by the blue light or ultraviolet light, like this, white light can be emitted evenly from a light emitting face 304a of the surface emitting illumination apparatus 300.

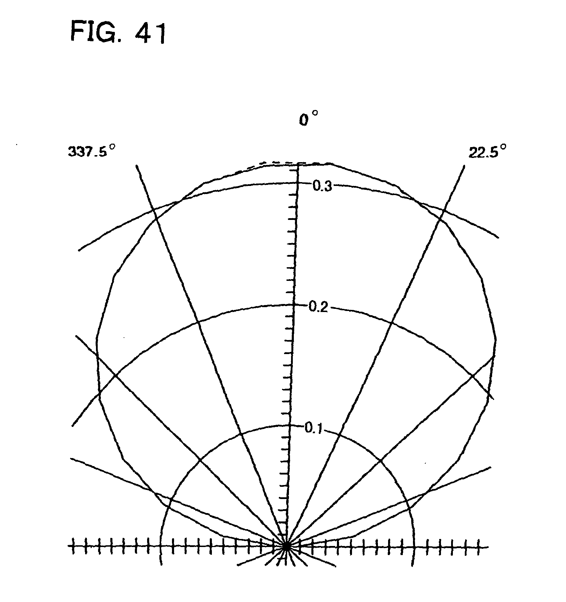

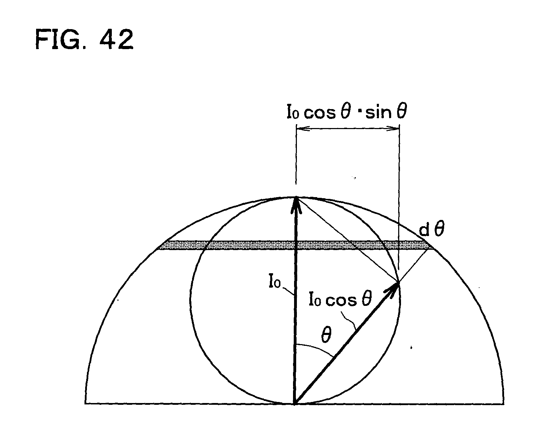

Subsequently, a distribution of light of a conventional light emitting device (see, for example, the light emitting device 100 in FIG. 55) with no transparent substrate or transparent member of polygonal pyramid shape or circular cone shape is shown in FIG. 41. As can be seen from FIG. 41, when no transparent substrate or transparent member of polygonal pyramid shape or circular cone shape is used, it becomes substantially perfect diffusion of light. As shown in FIG. 42, when an intensity of light emitted in a vertical direction (the axis of 0 degree) is designated by a symbol $I_0$,

and an angle in clockwise direction with respect to the vertical axis is designated by a symbol θ, an intensity of light emitted in the direction θ becomes $I_0 \cos \theta$. A light flux φ emitted in a region of an optional angle α with respect to the vertical axis is shown by the following equation.

$$\phi = I_0 \times 2\pi \int_0^\alpha \cos\theta \cdot \sin\theta \, d\theta$$
$$= I_0 \times \pi \left(1 - \cos^2 \alpha\right)$$

In addition, the total light flux from 0 degree to 90 degrees becomes $\phi_{90} = I_0 \times \pi$.

If the light emitting devices having such a distribution of light are disposed on the mounting substrate 302, the luminance at a position just above the light emitting device 301 on the fluorescent member serving as a light emitting face of the lighting apparatus becomes higher, and the luminance at a position between the light emitting devices 301 becomes lower, so that the distribution of luminance becomes uneven.

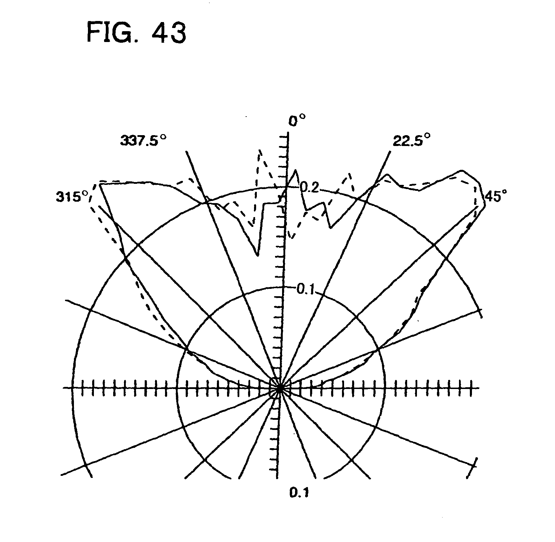

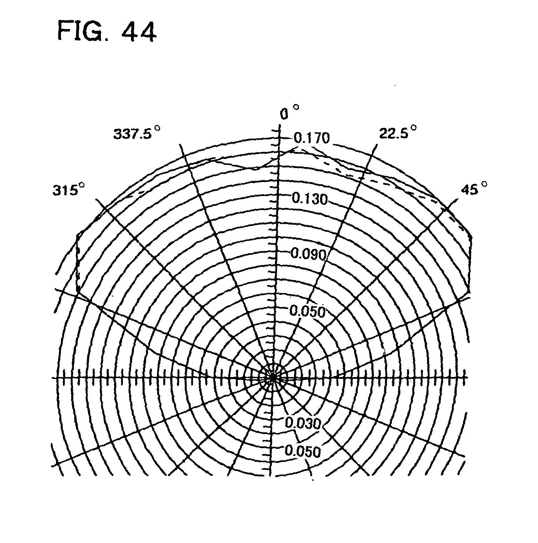

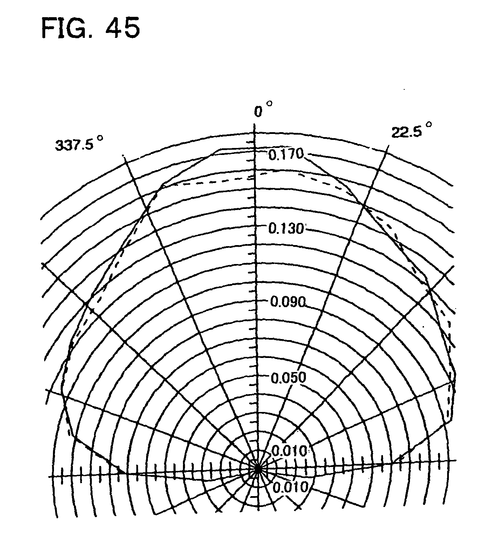

Subsequently, distributions of light of light emitting devices respectively having a transparent substrate or a transparent member of circular cone apex angle of which are 20 degrees,. 40 degrees and 60 degrees are shown in FIG. 43, FIG. 44 and FIG. 45. A solid line and a dotted line in each drawing respectively show the distributions of light on cross-sectional planes with a difference of 90 degrees. A light beam emitted from a light emitting device is repeated the reflection several times on faces forming the apex angle, that is, the exit faces of light, and emitted from the face forming the apex angle while an incident angle with respect to the faces forming the apex angle is gradually enlarged. By providing the transparent substrate or the transparent member of circular cone, like this, the distribution of light becomes that the light flux just above the light emitting device is reduced, and the components in the directions of predetermined angles are increased by just that much the reduction of the light flux. Specifically, in case of no transparent substrate or transparent member, the peak of relative luminous intensity is at the angle θ =0 degree. In case of providing the transparent substrate or transparent member of circular cone shape with the apex angle of 20 degrees, the peaks of relative luminous intensity are at the angles θ =45 degrees and θ =315 degrees. Furthermore, the smaller the apex angle becomes, the wider the distribution of light owing to the transparent substrate or the transparent member of circular cone shape becomes.

As just described, the light beams emitted from the light emitting device 301 are widely distributed and enter into the fluorescent member 304 by providing the transparent substrate or transparent member of circular cone shape on the light emitting device 301, so that the evenness of the luminance on the light emitting face 304a of the fluorescent member 304 is increased.

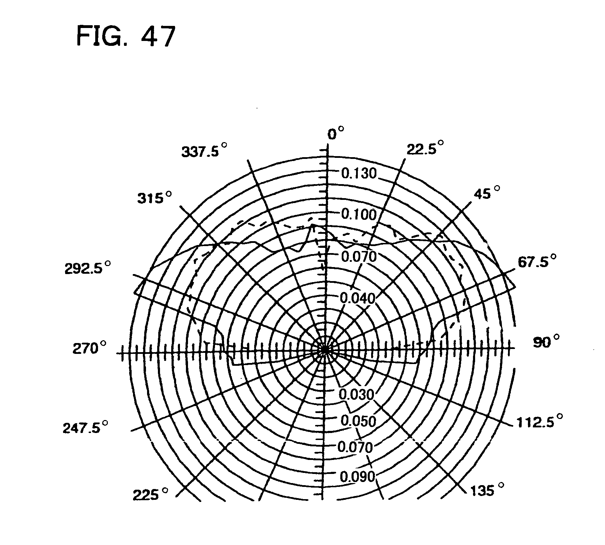

In addition, the shape of the transparent substrate or transparent member is not limited to the circular cone. It, however, is possible to shape it as a polygonal pyramid or another. FIG. 46A shows a light emitting device 301' with using a triangular prism shaped transparent substrate or transparent member 310. Distributions of light of this light emitting device 301' is shown in FIG. 47. In FIG. 47, a solid line shows a distribution of light in a direction of the triangular cross-section, and a dotted line shows a distribution of light in a direction of the rectangular cross-section. By using such a triangular prism shaped transparent substrate or transparent member 310, the light emitted from a light emitting portion of the light emitting device 301' can be distributed widely.

Furthermore, it is possible to mount a light emitting unit 62 alternative of the face down situation in which diode is formed on the side of the mounting substrate (not shown) and the face up situation in which the diode is formed on the side of the transparent substrate or transparent member 310.

By mounting such a light emitting device 301 on the mounting substrate 302 of the surface emitting illumination apparatus 300 shown in FIG. 40, the light beams emitted from the light emitting device are distributed widely and enter into the fluorescent member 304, so that the evenness of the luminance on the light emitting face 304a of the fluorescent member 304 is increased.

Furthermore, as shown in FIG. 46B, it is possible to dispose a plurality of light emitting units 62 on a rectangular shaped incident face of a single triangular prism shaped transparent substrate or transparent member 310. In such a case, the transparent substrate or transparent member 310 becomes relatively larger, so that molding and handling of it becomes easier, and it is possible to reduce a number of components of the surface emitting illumination apparatus 300, entirely.

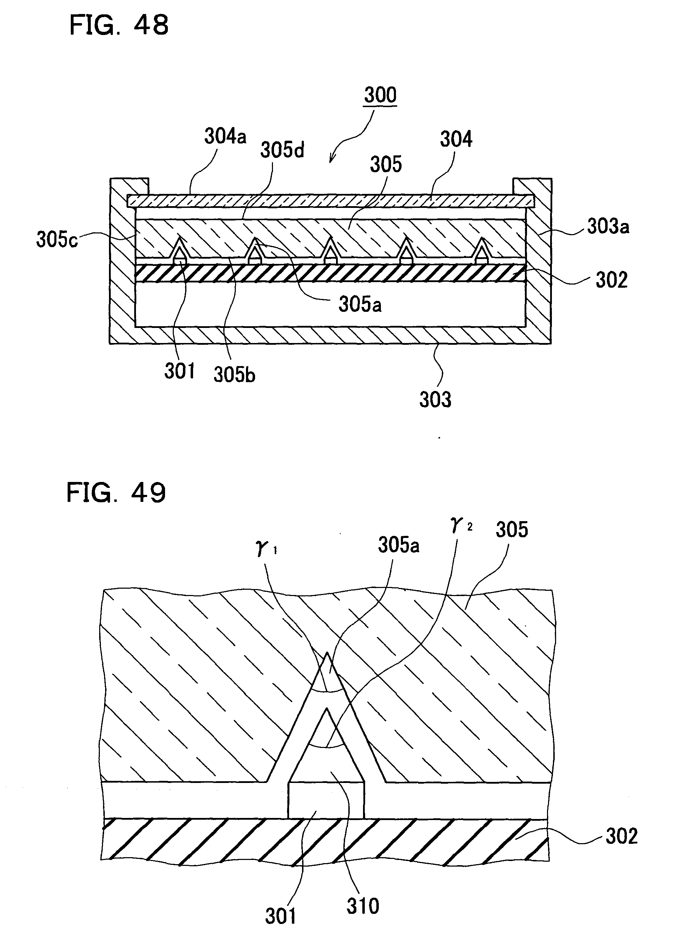

Subsequently, a second example of configuration of the surface emitting illumination apparatus 300 in accordance with the twelfth embodiment is shown in FIG. 48. In the second example of configuration of the surface emitting illumination apparatus 300, a light guide member 305 made of, for example, acrylic resin is provided between a mounting substrate 302 and a fluorescent member 304, further to the above-mentioned first example of configuration. Concave portions 305a are formed at positions facing light emitting devices 301 on a face of the light guide member 305 in the side of the mounting substrate 302, and at least a top end portion (preferably, entire) of a transparent substrate or transparent member of each light emitting device 301 is inserted into the concave portion 305a. Furthermore, white dot patterns are formed at portions 305b on the face of the light guide member 305, at which no concave portion 305a is formed, by micro-fabrication or silk-screen printing for aiming diffuse reflection. Still furthermore, mirror finish is carried out on end faces 305c of the light guide member 305.

In such the second example of configuration, most of the light beams emitted from the light emitting devices 301 through the transparent substrate or transparent member 310 enter into the concave portions 305b of the light guide member 305 with substantially the same angle. A light beam having an incident angle larger than a critical angle with respect to an exit face 305d of the light guide member 305 among the incident light of the light guide member 305 is repeated the reflection in the inside of the light guide member 305. The light beam is diffusedly reflected on the face 305b at which the diffusion reflection process is carried out, and finally emitted from the exit face 305d. Since the light emitted from the light emitting devices 301 is uniformized in a certain degree by guided in the light guide member 305, and enters into the fluorescent member 304, it is possible to increase the evenness of luminance on a light emitting face 304a of the fluorescent member 304.

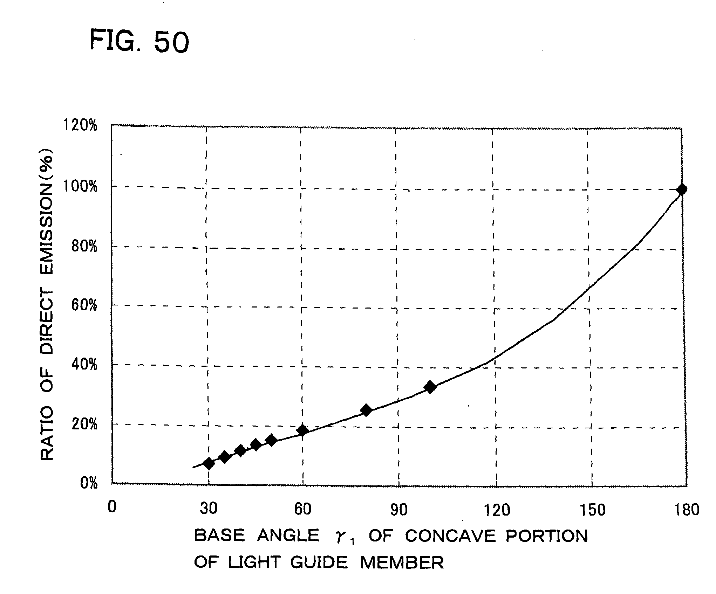

Subsequently, as shown in FIG. 49, it is assumed that an apex angle of the transparent substrate or transparent member 310 of the light emitting device 301 is designated by a symbol $\gamma_2$ (=40 degrees), and a base angle of the concave portion 305a of the light guide member 305 is designated by a symbol $\gamma_1$, and the base angle $\gamma_1$ is varied. A rate of light directly emitted without reflection in the light guide member 305 is shown in FIG. 50. As can be seen from FIG. 50, the smaller the base angle $\gamma_1$ of the concave portion 305a of the light guide member 305 is, the smaller the rate of the light beam directly emitted from the light guide member 305 becomes, and thus, the rate of the light beam repeatedly reflected in the light guide member 305 increases. When the base angle $\gamma_1$ of the concave portion 305a of the light guide member 305 is made smaller than the apex angle $\gamma_2$ (40 degrees) of the transparent substrate or transparent member 310 of the light emitting device 301, more than 80% of the light beams entering into the light guide member 305 are reflected in the light guide member 305. As a result, it is possible to make the luminance on the light emitting face 304a of the surface emitting illumination apparatus 300 more even.

Furthermore, though a number of components is increased by using the light guide member 305 in comparison with the first example of configuration shown in FIG. 41, density of irradiation to the fluorescent member can be uniformized owing to light guiding behavior in the light guide member 305. Thus, it is alternatively possible that a number of the light emitting devices is reduced, and that the distribution of illumination in the fluorescent member is made even, though the interval of the light emitting devices is enlarged.

Thirteenth Embodiment

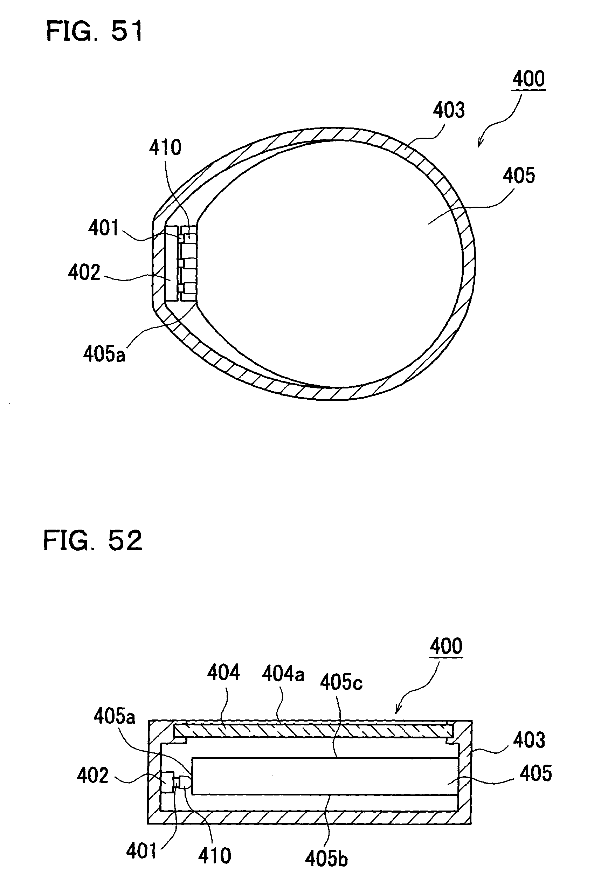

Subsequently, a thirteenth embodiment of the present invention is described. The thirteenth embodiment relates to a surface emitting illumination apparatus in which light emitting devices are disposed on a side face of a light guide member. FIG. 51 is a cross-sectional plan view of a surface emitting illumination apparatus 400 in accordance with the thirteenth embodiment, and FIG. 52 is a cross-sectional front view thereof.

As can be seen from the figures, a portion formed flat of a substantially cylindrical shaped side face of a substantially disc shaped light guide member 405 is used as an incident face 405a, and a mounting substrate 402 and a plurality of light emitting devices 401 mounted on the mounting substrate 402 are disposed for facing the incident face 405a. A diffuse reflection process such as a micro-fabrication or white dot pattern is carried out on a bottom face 405b of the light guide member 405 in a manner so that the density of it becomes higher corresponding to a distance from the light emitting devices 401. Furthermore, a fluorescent member 404 made of a material including fluorescent material is disposed with a predetermined gap with respect to an exit face 405c of the light guide member 405.

A transparent substrate or transparent member 410 of the light emitting device 401 is formed, for example, cylindrical lens shape (substantially cylindrical face shape) shown in FIG. 53, and a light emitting unit 62 is closely fixed on a rectangular bottom face of the transparent substrate or transparent member 410. Furthermore, as shown in FIG. 51, the light emitting devices 401 are mounted on the mounting substrate 402 in a manner so that the substantially semicircular shaped cross-section of the transparent substrate or transparent member 410 crosses a substantially circular cross-section of the light guide member 405 at right angle.

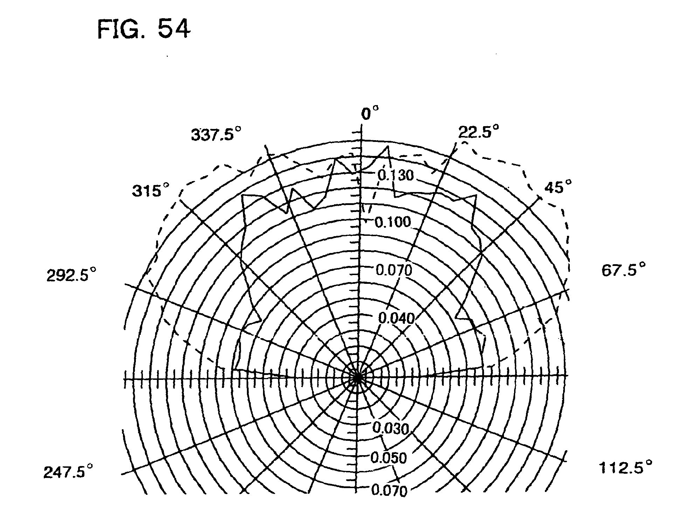

A distribution of light of the light emitting device 401 having the cylindrical lens shaped transparent substrate or transparent member 410 is shown in FIG. 54. In FIG. 54, a solid line shows a distribution of light in a direction of the substantially semicircular shaped cross-section, and the dotted line shows a distribution of light in a direction of the substantially rectangular cross-section. The distribution of light of the light emitting device 401 becomes relatively narrower distribution in the direction of the substantially semicircular shaped cross-section, and becomes wider distribution in the direction of the substantially rectangular cross-section.

By the way, it is possible to obtain substantially the same effect, when a plurality of light emitting units 62 is aligned on a bottom face of a single cylindrical lens.

Accordingly, the light emitted from the light emitting device 401 is distributed narrower in a direction of thickness of the light guide member 405, and distributed wider in a direction parallel to a plan of the light guide member 405, owing to the cylindrical lens shaped transparent substrate or transparent member 410. In this case, an incident angle of a light beam in the direction of the thickness of the light guide member 405 is smaller, so that a component totally reflected on the bottom face 505b (SIC: correctly 405b) and the exit face 405c of the light guide member 405 is increased.

As just described, when the light emitting devices 401 are disposed on the side face of the light guide member 405, it is possible to guide the light beams into whole gamut of the light guide member 405, and to make the luminance of a light emitting face 404a of the fluorescent member 404 of the surface emitting illumination apparatus 400 even. Furthermore, since the light emitting devices 401 are disposed on the side portion of the light guide member 405, maintenance such as replacement of the light emitting device 401 becomes easier.

Still furthermore, the cross-sectional shape not the rectangular of the cylindrical lens shaped transparent substrate or transparent member 410 is not limited to the semicircular. It is possible to make substantially semi-elliptic shape or another optional shape.

Still furthermore, it is needless to say that the features of the above-mentioned embodiments can be applied to both types of the light emitting devices for face down mounting and face up mounting.

This application is based on Japanese patent applications 2002-154262, 2002-218891 and 2002-218989 filed in Japan, the contents of which are hereby incorporated by references.

Although the present invention has been fully described by way of example with reference to the accompanying drawings, it is to be understood that various changes and modifications will be apparent to those skilled in the art. Therefore, unless otherwise such changes and modifications depart from the scope of the present invention, they should be construed as being included therein.

**Claims**

1. A non-sealed type light emitting device having a diode structure which is formed by lamination of an n-type semiconductor layer and a p-type semiconductor layer on a face of a transparent substrate, and **characterized by** that an exit face of light is not in parallel with a face among respective faces of the diode structure which is opposite to the transparent substrate.

2. The light emitting device in accordance with claim 1, **characterized by** that a face of the transparent substrate facing the face on which the diode structure serves as the exit face of light; and it is a slanted face with respect to the face among respective faces of the diode structure which is opposite to the transparent substrate, a rough face, a substantially pyramid or cone shape, a substantially spherical shape, a face on which a plurality of convex portions of substantially pyramid or cone shape or substantially spherical shape is arranged, or a substantially cylindrical shape.

3. The light emitting device in accordance with claim 2, **characterized by** that the exit face of light is substantially pyramid or cone shape; and a ratio of a height with respect to a maximum width of a bottom face of the substantially pyramid or cone shape is equal to or larger than about 0.4 and equal to or smaller than about 4.5.

4. The light emitting device in accordance with claim 2, **characterized by** that the exit face of light is substantially spherical shape; and a ratio of a height with respect to a diameter of a bottom face of the substantially spherical shape is equal to or larger than about 0.3 and equal to or smaller than about 0.5.

5. The light emitting device in accordance with claim 1, **characterized by** that the transparent substrate is configured by a parallel plate made of a first material and having a first face on which the diode structure is formed and a second face in parallel with the first face, and a transparent member made of a second material and having a third face connected with the second face of the parallel plate and a fourth face opposite to the third face; the fourth of the transparent member is not in parallel with the face among respective faces of the diode structure which is opposite to the transparent substrate; and the fourth face of the transparent member serves as the exit face of light.

6. The light emitting device in accordance with claim 5, **characterized by** that the fourth face of the transparent member is a slanted face with respect to the face among respective faces of the diode structure which is opposite to the transparent substrate, a rough face, a substantially pyramid or cone shape, a substantially spherical shape, a face on which a plurality of convex portions of substantially pyramid or cone shape or substantially spherical shape is arranged, or a substantially cylindrical shape.

**7.** The light emitting device in accordance with claim 1, **characterized by** that a transparent member connected with the face among respective faces of the diode structure which is opposite to the transparent substrate is further comprised, and a dace of the transparent member opposite to a connecting face with the diode structure serves as the exit face of light.

**8.** The light emitting device in accordance with claim 7, **characterized by** that the exit face of light is a slanted face with respect to the face among respective faces of the diode structure which is opposite to the transparent substrate, a rough face, a substantially pyramid or cone shape, a substantially spherical shape, a face on which a plurality of convex portions of substantially pyramid or cone shape or substantially spherical shape is arranged, or a substantially cylindrical shape.

**9.** A lighting apparatus comprising a non-sealed type light emitting apparatus mounted on a mounting substrate, and a fluorescent member disposed in front of an exit face of light of the light emitting device, which is excited by a light emitted from the light emitting device and emits a light of different wavelength from excitation wavelength, and **characterized by** that the light emitting device has a diode structure which is formed by lamination of an n-type semiconductor layer and a p-type semiconductor layer on a face of a transparent substrate, and the exit face of light is not in parallel with a face among respective faces of the diode structure which is opposite to the transparent substrate.

**10.** The lighting apparatus in accordance with claim 9, **characterized by** that an optical member comprising the fluorescent member on a surface or inside is detachable mounted on the mounting substrate.

**11.** The lighting apparatus in accordance with claim 9, **characterized by** that the optical member has a convex lens shape.

**12.** The lighting apparatus in accordance with claim 9, **characterized by** that the light emitting device is mounted on a bottom face of a concave portion formed on the mounting substrate; and a face of the transparent member facing the light emitting device is substantially the same size as that of an opening of the concave portion.

**13.** The lighting apparatus in accordance with claim 12, **characterized by** that an inner face of the concave portion is firmed substantially paraboloid or substantially ellipsoidal, and the light emitted from the light emitting device is reflected on the inner face of the concave portion so as to enter it into the fluorescent member.

**14.** The lighting apparatus in accordance with claim 12, **characterized by** that a transparent resin is filled in the concave portion in a manner so that at least a part of the exit face of the light emitting device.

**15.** The lighting apparatus in accordance with claim 14, **characterized by** that a member having a function serving as the exit face of light of the light emitting device and the transparent resin filled in the concave portion are substantially the same material.

**16.** The lighting apparatus in accordance with claim 14, **characterized by** that the transparent substrate is configured by a parallel plate made of a first material, and a transparent member made of a second material and connected to the parallel plate; a non-connection face of the transparent member serves as the exit face of light; and the parallel plate and the transparent member are closely disposed via a transparent connection layer made of a material having an intermittent refraction index between the refraction index of the first material and the refraction index of the second material.

**17.** The lighting apparatus in accordance with claim 14 (SIC: correctly 15), **characterized by** that at least a part of the member having the function serving as the exit face of light of the light emitting device is protruded outward from the exit face of light toward the transparent resin filled in the concave portion.

**18.** A surface emitting illumination apparatus comprising one or a plurality of non-sealed type light emitting apparatuses mounted on a mounting substrate, and a fluorescent member which is excited by a light emitted from the light emitting device and emits a light of different wavelength from excitation wavelength, and **characterized by** that the light emitting device has a diode structure which is formed by lamination of an n-type semiconductor layer and a p-type semiconductor layer on a face of a transparent substrate, and the exit face of light is not in parallel with a face among respective faces of the diode structure which is opposite to the transparent substrate.

**19.** The surface emitting illumination apparatus in accordance with claim 18, **characterized by** that a light guide member is provided between the exit face of light of the light emitting device and the fluorescent member.

**20.** The surface emitting illumination apparatus in accordance with claim 18, **characterized by** that a cross-section of the exit face of light of the light emitting device in a predetermined direction is formed in a manner so that a width thereof becomes narrower corresponding to a distance from a light emitting face of the light emitting device.

**21.** The surface emitting illumination apparatus in accordance with claim 20, **characterized by** that the exit face of light of the light emitting device is substantially pyramid shape or cone shape, combination of a plurality of slant faces or substantially cylindrical shape.

**22.** The surface emitting illumination apparatus in accordance with claim 20, **characterized by** that a concave portion having substantially the same shape as the exit face of light of the light emitting device is formed at a position facing each light emitting device on a face of the light guide member facing the light emitting device; and at least a part of the exit face of light of the light emitting device is inserted into the concave portion.

**23.** The surface emitting illumination apparatus in accordance with claim 19, **characterized by** that the light emitting device is disposed for facing a side face perpendicular to an exit face of light of the light guide member; and the fluorescent member is disposed for facing the exit face of light of the light guide member.

FIG. 1

FIG. 2

FIG. 3

FIG. 4

FIG. 5

FIG. 6A

21b

$\theta$

FIG. 6B

21b

FIG. 6C

$\theta$

21b

FIG. 7

FIG. 8

FIG. 9A

FIG. 9B

FIG. 10

FIG. 11A

FIG. 11B

FIG. 12A

FIG. 12B

FIG. 13

## FIG. 14A

## FIG. 14B

EP 1 536 487 A1

FIG. 15A

40

41B

41A ,12

a

FIG. 15B

41a  40

41a

41B  } 41
41A

b

41b

14a  15  14  13

12

## FIG. 16A

## FIG. 16B

FIG. 17

FIG. 18

FIG. 19

FIG. 20

FIG. 21

FIG. 22

FIG. 23

FIG. 24

FIG. 25

## FIG. 26

40 "

41B ⎫
    ⎬ 41
41A ⎭

14  13  14  13  14  13

15  12  15  12  15  12

## FIG. 27

60

61

62   62   62

FIG. 28

FIG. 29

FIG. 30

FIG. 31

## FIG. 32

## FIG. 33

## FIG. 34

205 , 211

204

203

202    201

## FIG. 35

205 , 211

204

203

202    201

FIG. 36

FIG. 37

## FIG. 38

REGION OF
SECOND
EQUATION

REGION OF FIRST EQUATION

FIG. 39

FIG. 40

FIG. 41

FIG. 42

$I_0 \cos \theta \cdot \sin \theta$

$d\theta$

$I_0$

$I_0 \cos \theta$

$\theta$

## FIG. 43

## FIG. 44

FIG. 45

## FIG. 46A

## FIG. 46B

# FIG. 47

FIG. 48

FIG. 49

FIG. 50

BASE ANGLE $\gamma_1$ OF CONCAVE PORTION
OF LIGHT GUIDE MEMBER

RATIO OF DIRECT EMISSION(%)

# FIG. 51

# FIG. 52

FIG. 53

## FIG. 54

FIG. 55 (PRIOR ART)

## INTERNATIONAL SEARCH REPORT

| | International application No. |
|---|---|
| | PCT/JP03/06715 |

A. CLASSIFICATION OF SUBJECT MATTER
   Int.Cl⁷ H01L33/00, F21V8/00

According to International Patent Classification (IPC) or to both national classification and IPC

B. FIELDS SEARCHED

Minimum documentation searched (classification system followed by classification symbols)
   Int.Cl⁷ H01L33/00, F21V8/00

Documentation searched other than minimum documentation to the extent that such documents are included in the fields searched
   Jitsuyo Shinan Koho          1922–1996    Toroku Jitsuyo Shinan Koho    1994–2003
   Kokai Jitsuyo Shinan Koho    1971–2003    Jitsuyo Shinan Toroku Koho    1996–2003

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 2-198178 A (Hitachi, Ltd., Hitachi Tohbu<br>Semiconductor, Ltd.),<br>06 August, 1990 (06.08.90),<br>Full text; Figs. 2<br>(Family: none) | 1,2,4<br>3,5,6,8,9,18 |
| X<br>Y | JP 11-261109 A (Toshiba Corp.),<br>24 September, 1999 (24.09.99),<br>Full text; all drawings<br>(Family: none) | 1,2,5,6,9,<br>18,20,21<br>3,4,7,8,<br>10-17 |
| X<br>Y | JP 4-307976 A (NEC Corp.),<br>30 October, 1992 (30.10.92),<br>Full text; Fig. 1<br>(Family: none) | 1,2,5,6<br>4,7-9,11,18 |

☒ Further documents are listed in the continuation of Box C.     ☐ See patent family annex.

| * Special categories of cited documents: | "T" later document published after the international filing date or |
|---|---|
| "A" document defining the general state of the art which is not considered to be of particular relevance | priority date and not in conflict with the application but cited to understand the principle or theory underlying the invention |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 26 August, 2003 (26.08.03) | 09 September, 2003 (09.09.03) |

| Name and mailing address of the ISA/<br>Japanese Patent Office | Authorized officer |
|---|---|
| Facsimile No. | Telephone No. |

Form PCT/ISA/210 (second sheet) (July 1998)

**INTERNATIONAL SEARCH REPORT**

| International application No. |
|---|
| PCT/JP03/06715 |

C (Continuation).   DOCUMENTS CONSIDERED TO BE RELEVANT

| Category* | Citation of document, with indication, where appropriate, of the relevant passages | Relevant to claim No. |
|---|---|---|
| X<br>Y | US 2001/0010449 A1  (Industrial Technology<br>Research Institute),<br>10 August, 2001 (10.08.01),<br>Full text; all drawings<br>& JP 2001-217467 A       & TW 465123 A | 1,2,5,9,18<br>3,4,7,8,10,<br>11 |
| Y | WO 01/41219 A1  (Cree Lighting Co.),<br>07 June, 2001 (07.06.01),<br>Full text; all drawings<br>& US 6410942 B1         & EP 1234334 A1<br>& AU 200117905 A        & KR 2002069357 A<br>& CN 1402880 A | 1-18,20,21 |
| Y | JP 2001-345482 A  (Toshiba Corp., Toshiba<br>Electronic Engineering Corp.),<br>14 December, 2001 (14.12.01),<br>Full text; all drawings<br>(Family: none) | 9,11-16 |
| Y | JP 8-7614 A  (Nichia Chemical Industries, Ltd.),<br>12 January, 1996 (12.01.96),<br>Full text; all drawings<br>(Family: none) | 10,19,23 |
| Y | JP 2000-156526 A  (Asahi Rubber Corp.),<br>06 June, 2000 (06.06.00),<br>Full text; Fig. 7<br>(Family: none) | 19,22 |

Form PCT/ISA/210 (continuation of second sheet) (July 1998)